# EUROPEAN PATENT APPLICATION

(11) **EP 4 775 066 A1**
(43) Date of publication of application: **15.07.2026**
(21) Application number: 24863317.4
(22) Date of filing: 29.08.2024
(51) Int. Cl.: A24F 40/50, A24F 40/51, A24F 40/53, A24F 40/57, A24F 40/46, A24F 40/60, H05B 6/64, H05B 6/68, G01R 27/16

(54) **AEROSOL-GENERATING DEVICE, AND METHOD FOR CONTROLLING AEROSOL-GENERATING DEVICE**

(30) Priority: 06.09.2023 KR 20230118554
(71) Applicant: KT&G Corporation, Daedeok-gu Daejeon 34337 (KR)
(72) Inventor: PARK, Sang Kyu, Seoul 05281 (KR); AHN, Hyun Ho, Seoul 04773 (KR); OH, Jun Yeop, Seoul 02559 (KR); LEE, Won Kyeong, Guri-si, Gyeonggi-do 11920 (KR); JEONG, Jong Seong, Sejong 30126 (KR)
(74) Representative: AWA Sweden AB
(86) International application number: PCT/KR2024/096093
(87) International publication number: WO 2025/053738

(57) **Abstract**

An aerosol generating device may be provided, the aerosol generating device including a housing, a heater assembly including an oscillation unit configured to generate a microwave in a designated frequency band and a resonation unit configured to receive the generated microwave from the oscillation unit through a coupler and generate an electric field by resonating the received microwave, a sensor arranged inside the housing and configured to detect insertion of a metal into an accommodation space for accommodating an aerosol generating article therein, and a processor electrically connected to the sensor and configured to block power supply to the oscillation unit when the insertion of the metal into the accommodation unit is detected.

## Description

### Technical Field

Embodiments relate to an aerosol generating device and a method of controlling the aerosol generating device, in which an aerosol may be generated by heating an aerosol generating article using a dielectric heating method.

### Background Art

Recently, there has been an increasing demand for alternative methods that reduce disadvantages of general cigarettes. For example, there has been an increasing demand for a device (or an "aerosol generating device") that generates an aerosol by heating an aerosol generating material (or an "aerosol generating article") by using the aerosol generating device, instead of a method of generating an aerosol by burning a cigarette.

Thus, aerosol generating devices for generating an aerosol by heating an aerosol generating material in a resistance heating or inductive heating manner have received much attention, and recently, interest in aerosol generating devices using a dielectric heating method in which an aerosol generating material is heated using microwaves has also increased.

### Disclosure of Invention

### Technical Problem

When a foreign substance other than an aerosol generating material is introduced into an aerosol generating device using a dielectric heating method, excessive heat may be generated, causing the aerosol generating device to malfunction or become damaged. For example, when a foreign substance, such as a metal with high electrical conductivity, is introduced into the aerosol generating device using the dielectric heating method, excessive heat may be generated from the metal, causing a surface temperature of the aerosol generating device to rise excessively high or a heater assembly to be damaged by the heat.

Accordingly, various embodiments of the present disclosure provide an aerosol generating device in which introduction of a metal is detected so that a heating operation may be ceased when the metal is introduced, thereby preventing malfunction or damage due to the introduction of the metal and improving user convenience.

Problems to be solved by embodiments of the present disclosure are not limited to the problems described above, and problems not described above may be clearly understood by a person having ordinary skill in the art to which the embodiments belong from the present specification and the attached drawings.

### Solution to Problem

An aerosol generating device according to an embodiment may include a housing, a heater assembly including an oscillation unit configured to generate a microwave in a designated frequency band and a resonation unit configured to receive the generated microwave from the oscillation unit through a coupler and generate an electric field by resonating the received microwave, a sensor arranged inside the housing and configured to detect insertion of a metal into an accommodation space for accommodating an aerosol generating article therein, and a processor electrically connected to the sensor and configured to block power supply to the oscillation unit when the insertion of the metal into the accommodation unit is detected.

A method of controlling an aerosol generating device, according to an embodiment, may include detecting, by a sensor arranged outside a housing, insertion of a metal into an accommodation space for accommodating an aerosol generating article, and when the insertion of the metal into the accommodation space is detected by the sensor, blocking power supply to an oscillation unit.

According to an embodiment, an aerosol generating device includes a housing including an insertion hole into which an aerosol generating article is inserted and the heater assembly for heating the aerosol generating article inserted through the insertion hole.

### Advantageous Effects of Invention

In an aerosol generating device and a method of controlling an aerosol generating device, according to various embodiments of the present disclosure, user convenience may be improved while preventing the risk of failure and explosion of the aerosol generating device, which may occur when a foreign substance, such as metal, is inserted into the aerosol generating device using a dielectric heating method.

The effects of embodiments are not limited to the effects described above, and effects not mentioned can be clearly understood by one of ordinary skill in the art to which the embodiments belong from the present specification and the accompanying drawings.

### Brief Description of Drawings

FIG. 1 is a perspective view of an aerosol generating device according to an embodiment.
FIG. 2 is an internal block diagram of an aerosol generating device according to an embodiment.
FIG. 3 is an internal block diagram of a dielectric heating unit of FIG. 2.
FIG. 4 is a perspective view of a heater assembly according to an embodiment.
FIG. 5 is a cross-sectional view of the heater assembly of FIG. 4.
FIG. 6 is a perspective view of a heater assembly according to another embodiment.
FIG. 7A is a diagram illustrating an example of a sensor provided in a heater assembly, according to an embodiment.
FIG. 7B is a diagram illustrating another example of a sensor provided in a heater assembly, according to an embodiment.
FIG. 7C is a diagram illustrating an example of a sensor provided in a heater assembly, according to another embodiment.
FIG. 7D is a diagram illustrating another example of a sensor provided in a heater assembly, according to another embodiment.
FIG. 8 is a flowchart of a method of controlling an aerosol generating device, according to an embodiment.
FIG. 9 is a flowchart of a method of controlling an aerosol generating device, according to another embodiment.
FIG. 10 is a block diagram of an aerosol generating device according to another embodiment.

### Best mode for Carrying out the Invention

An aerosol generating device according to an embodiment includes a housing, a heater assembly including an oscillation unit configured to generate a microwave in a designated frequency band and a resonation unit configured to receive the generated microwave from the oscillation unit through a coupler and generate an electric field by resonating the received microwave, a sensor arranged inside the housing and configured to detect insertion of a metal into an accommodation space for accommodating an aerosol generating article therein, and a processor electrically connected to the sensor and configured to block power supply to the oscillation unit when the insertion of the metal into the accommodation unit is detected.

The sensor may be located outside the resonation unit and arranged in one area adjacent to the accommodation space.

The aerosol generating device may further include a support located outside the resonation unit, and arranged to surround an outer surface of the aerosol generating article accommodated in the accommodation space to support the accommodated aerosol generating article, wherein the sensor is arranged inside the support.

The sensor may be a ring-shaped coil which surrounds an outer surface of the aerosol generating article inserted into the accommodation space.

The sensor may be a plate-shaped coil which surrounds an outer surface of the aerosol generating article inserted into the accommodation space.

When the processor supplies power to the sensor at preset intervals, the sensor may detect a change in inductance of the accommodation space at the preset intervals.

The sensor may detect a change in inductance of the accommodation space, and when a frequency change corresponding to the change in inductance detected by the sensor is greater than or equal to a preset frequency change, the processor may block a power supply to the oscillation unit.

The aerosol generating device may further include a display arranged in one area of the housing, wherein, when the insertion of the metal into the accommodation space is detected by the sensor, the processor is configured to control the display to display a notification of unavailableness of the aerosol generating device.

When removal of the metal which had been inserted into the accommodation space is detected by the sensor, the processor is configured to control that the display to display a notification of availableness of the aerosol generating device.

The resonation unit may include an outer conductor including a first surface, a second surface facing the first surface, a side surface surrounding an internal space between the first surface and the second surface, and the accommodation space, and a first internal conductor which extends in a direction from the first surface toward the internal space to surround one area of the aerosol generating article accommodated in the accommodation space.

The resonation unit may further include a second internal conductor which extends in a direction from the second surface toward the internal space to surround another area of the accommodated aerosol generating article.

The resonation unit further may further include a dielectric accommodation space formed between the outer conductor and the first internal conductor, and a dielectric arranged in the dielectric accommodation space.

The dielectric may be spaced apart from the second surface or side surface of the outer conductor by a certain distance.

A method of controlling an aerosol generating device, according to an embodiment, includes detecting, by a sensor arranged inside a housing, insertion of a metal into an accommodation space for accommodating an aerosol generating article, and when the insertion of the metal into the accommodation space is detected by the sensor, blocking power supply to an oscillation unit.

The detecting of the insertion of the metal may include detecting based on a change in inductance of the accommodation space detected by the sensor, and the blocking of the power supply to the oscillation unit may include, when a frequency change corresponding to the detected change in inductance is greater than or equal to a preset frequency change, blocking the power supply to the oscillation unit.

### Mode for the Invention

Hereinafter, embodiments disclosed in this specification will be described in detail with reference to the accompanying drawings, and identical or similar components will be assigned the same reference numbers, regardless of the drawing symbols, and redundant explanations will be omitted.

The suffixes "module" and "unit" used in this description are assigned or used interchangeably solely for the convenience of drafting the specification and do not themselves have distinct meanings or roles.

Also, in describing the embodiments disclosed in this specification, detailed descriptions of well-known technologies may be omitted if it is determined that they could obscure the essence of the embodiments disclosed herein. Additionally, the accompanying drawings are provided merely to facilitate the understanding of the embodiments disclosed in this specification, and the technical spirit disclosed herein is not limited by the drawings. It should be understood that all modifications, equivalents, and substitutes that fall within the spirit and scope of this disclosure are included.

Terms including ordinal numbers, such as first, second, etc., may be used to describe various components, but the components are not limited by the terms. The above terms are used solely to distinguish one component from another.

When a component is referred to as being "connected" or "coupled" to another component, it should be understood that the component may be directly connected or coupled to the other component, or there may be intervening components in between. On the other hand, when a component is referred to as being "directly connected" or "directly coupled" to another component, it should be understood that there are no intervening components in between.

Singular expressions include plural expressions unless the context clearly indicates otherwise.

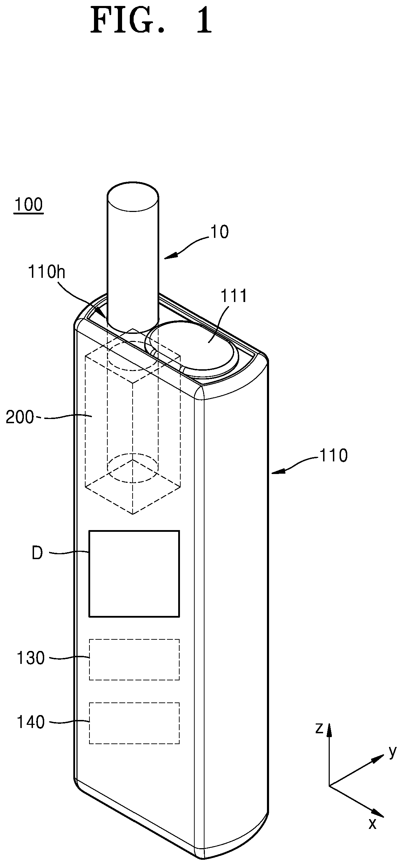

FIG. 1 is a perspective view of an aerosol generating device according to an embodiment.

Referring to FIG. 1, an aerosol generating device 100 according to an embodiment may include a housing 110 including an accommodation space 110h for accommodating an aerosol generating article 10, a heater assembly 200 for heating the aerosol generating article 10 accommodated in the housing 110, a sensor 150 for detecting insertion of metal into the accommodating space 110h and a processor 130.

The housing 110 may form the overall exterior of the aerosol generating device 100, and components of the aerosol generating device 100 may be arranged in an inner space (or a 'mounting space') of the housing 110. For example, the heater assembly 200, a battery, a processor, and/or a sensor may be arranged in the inner space of the housing 110, but the components arranged in the inner space are not limited thereto.

The housing 110 may include an accommodation space 110h for accommodating an aerosol generating article 10, and at least one area of the aerosol generating article 10 may be inserted or received within the accommodation space 110h. For example, the accommodation space 110h may be formed in a portion of an upper surface (e.g., a surface in a z direction) of the housing 110, but the position of the accommodation space 110h is not limited thereto. In another embodiment, the accommodation space 110h may be formed in a portion of a side surface (e.g., a surface in an x direction) of the housing 110.

The heater assembly 200 may be arranged in the inner space of the housing 110 and heat the aerosol generating article 10 inserted into or accommodated in the housing 110 through the accommodation space 110h. For example, the heater assembly 200 may be positioned to surround at least a portion of the aerosol generating article 10 inserted into or accommodated in the accommodation space 110h, thus heating the aerosol generating article 10.

According to an embodiment, the heater assembly 200 may heat the aerosol generating article 10 by using a dielectric heating method. In the present specification, the term 'dielectric heating method' refers to a method of heating a dielectric material, which is a heating object, by using resonance of microwaves and/or an electric field (which may include a magnetic field) of the microwaves. Microwaves are energy sources used to heat a heating object and are generated by high-frequency power, and thus, the term 'microwave' may hereinafter be used interchangeably with microwave power.

Charges or ions in a dielectric material included in the aerosol generating article 10 may vibrate or rotate because of microwave resonance within the heater assembly 200, and frictional heat generated during the vibration or rotation of the charges or ions may cause heat to be generated from the dielectric material such that the aerosol generating article 10 may be heated.

As the aerosol generating article 10 is heated by the heater assembly 200, an aerosol may be generated from the aerosol generating article 10. In the present specification, the term 'aerosol' may refer to gaseous particles generated from a mixture of vapor and air that are produced as the aerosol generating article 10 is heated.

The aerosol generated from the aerosol generating article 10 may pass through the aerosol generating article 10 or may be discharged to the outside of the aerosol generating device 100 through an empty space between the aerosol generating article 10 and the accommodation space 110h. A user may place their mouth on a portion of the aerosol generating article 10 exposed to the outside of the housing 110 and may inhale the aerosol discharged from the aerosol generating device 100, thereby smoking.

The sensor 120 may be arranged in an area adjacent to the accommodation space 110h within the housing 110 so as to detect insertion of a metal material (hereinafter, referred to as "metal") into the accommodation space 110h. For example, the sensor 120 may be located outside the heater assembly 200 and in an area of an outer circumference surface of an aerosol generating article inserted into the accommodation space 110h.

Because metals includes numerous free electrons therein, when a metal is heated using a dielectric heating method, numerous free electrons in the metal may vibrate or rotate simultaneously. When a metal having a size and/or thickness enough to be inserted into the accommodation space 110h of the aerosol generating device 1000 is dielectrically heated by the heater assembly 200, the movement of numerous free electrons inside the metal may become very violent, so that the metal may be heated very quickly.

In a state where a metal is inserted into the accommodation space 110h, when the heater assembly 200 heats an aerosol generating material 10 by using the dielectric heating method, the heating efficiency of the aerosol generating device 1000 may not be high because the metal is heated faster than the aerosol generating material 10. In some embodiments, the metal may be heated to ignite, causing the aerosol generating device 1000 to explode.

The sensor 120 may be an inductance sensor for detecting a change in inductance within the accommodation space 110h, and the aerosol generating device 100 according to an embodiment may detect whether a metal has been inserted into the accommodation space 110h based on the change in inductance of the accommodation space 110h detected by the sensor 120. For example, the processor 130 may detect a change in frequency corresponding to a change in inductance detected by the sensor 120, and when it is determined that the detected change in frequency is greater than or equal to a preset frequency change, determine that a metal has been inserted into the accommodation space 110h.

The processor 130 may control the overall operation of the aerosol generating device 1000.

The aerosol generating device 1000 according to an embodiment may further include a display D and a cover 111. The processor 130 may be implemented as an array of multiple logic gates. The processor 130 may be implemented as a combination of a general-purpose microprocessor and a memory storing a program that can be executed on the microprocessor. Additionally, the processor 130 may be implemented in other forms of hardware.

For example, the processor 130 may supply power from the battery 140 to the sensor 150 and detect, by using the sensor 150, whether a metal has been inserted into the accommodation space 110h. In another example, the processor 130 may control power supplied from the battery 140 to the heater assembly 200.

The display D may be arranged in an area of the housing 110 and may display various visual information. For example, the display D may display a notification that the aerosol generating device 1000 is unavailable. When it is detected by the sensor 150 that a metal has been inserted into the accommodation space 110h, the aerosol generating device 1000 may display, through the display D, that the aerosol generating device 1000 is unavailable.

In another example, the display D may display a notification that the aerosol generating device 1000 is available. When it is detected by the sensor 150 that a metal which had been inserted into the accommodation space 110h has been removed, the aerosol generating device 1000 may display, through the display D, that the aerosol generating device 1000 is available.

The aerosol generating device 1000 according to an embodiment may further include the cover 111 which is movably arranged in the housing 110 to open or close the accommodation space 110h. For example, the cover 111 may be slidably coupled to an upper surface of the housing 110, and may expose the accommodation space 110h to the outside of the aerosol generating device 1000 or may cover the accommodation space 110h so that the accommodation space 110h is not exposed to the outside of the aerosol generating device 1000.

For example, at a first position (or "opened position"), the cover 111 may expose the accommodation space 110h to the outside of the aerosol generating device 1000. When the aerosol generating device 1000 is exposed to the outside, the aerosol generating article 10 may be inserted into the housing 110 through the accommodation space 110h.

In another example, the cover 111 may cover the accommodation space 110h at a second position (or "closed position") so that the accommodation space 110h is not exposed to the outside of the aerosol generating device 1000. In this case, when the aerosol generating device 1000 is not in use, the cover 111 may prevent foreign substances from entering the heater assembly 200 through the accommodation space 110h.

In FIG. 1, only the aerosol generating article 10 for heating the aerosol generating article 10 in a solid state is shown. However, the aerosol generating device 1000 is not limited to the embodiment shown.

In another example, an aerosol generating device according to an embodiment may generate an aerosol by heating, through the heater assembly 200, a liquid- or gel-type aerosol generating material rather than the aerosol generating article 10 in the solid state. In addition, in another example, an aerosol generating device according to an embodiment may include the heater assembly 200 for heating the aerosol generating article 10, and a liquid- or gel-type aerosol generating material, or may include a cartridge (or "vaporizer") for heating an aerosol generating material. An aerosol generated from the aerosol generating material may move to the aerosol generating article 10 along an airflow passage connecting the cartridge and the aerosol generating article 10, and may be mixed with the aerosol generated from the aerosol generating article 10 and then delivered to the user through the aerosol generating article 10.

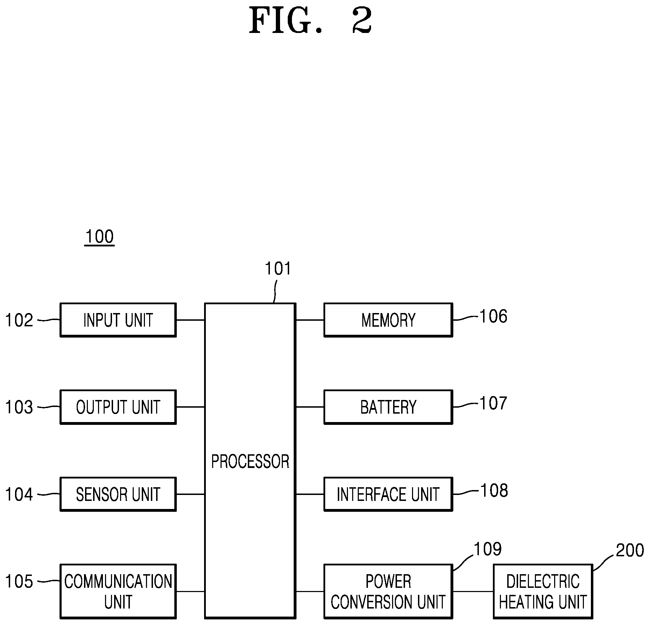

FIG. 2 is an internal block diagram of an aerosol generating device according to an embodiment.

Referring to FIG. 2, the aerosol generating device 100 may include an input unit 102, an output unit 103, a sensor unit 104, a communication unit 105, a memory 106, a battery 107, an interface unit 108, a power converter 109, and a dielectric heating unit 200. However, components of the aerosol generating device 100 are not limited to that illustrated in Fig. 2. Depending on design of the aerosol generating device 100, some of the components illustrated in Fig. 2 may be omitted or new component may be added.

The input unit 102 may receive a user input. For example, the input unit 102 may be a single pressure-type push button. As another example, the input unit 102 may be a touch panel including at least one touch sensor. The input unit 102 may transmit an input signal to a processor 101. The processor 101 may supply power to the dielectric heating unit 200 based on a user input or control the output unit 103 to output a user notification.

The output unit 103 may output information on a state of the aerosol generating device 100. The output unit 103 may output a charge/discharge state of the battery 107, a heating state of the dielectric heating unit 200, an insertion state of the aerosol generating article 10, and error information of the aerosol generating device 100. To this end, the output unit 103 may include a display, a haptic motor, and a sound output unit.

The sensor unit 104 may sense a state of the aerosol generating device 100 and a state around the aerosol generating device 100 and may transmit sensed information to the processor 101. Based on the sensed information, the processor 101 may control the aerosol generating device 100 to perform various functions, such as heating control of the dielectric heating unit 200, limiting smoking, determining whether the aerosol generating article 10 is inserted, and displaying a notification.

The sensor unit 104 may include a temperature sensor, a puff sensor, and an insertion detection sensor.

The temperature sensor may sense an internal temperature of the dielectric heating unit 200 in a non-contact manner or may contact the dielectric heating unit 200 to thus directly obtain a temperature of a resonator. According to an embodiment, the temperature sensor may also sense the temperature of the aerosol generating article 10. In addition, the temperature sensor may be arranged adjacent to the battery 107 and obtain the temperature thereof. The processor 101 may control the power supplied to the dielectric heating unit 200, based on temperature information of the temperature sensor.

The puff sensor may detect a user's puff. The puff sensor may sense a user's puff on the basis of at least one of a temperature change, a flow change, a power change, and a pressure change. The processor 101 may control the power supplied to the dielectric heating unit 200, based on puff information from the puff sensor. For example, the processor 101 may count the number of puffs, and when the number of puffs reaches a preset maximum number of puffs, the processor 101 may block the power supplied to the dielectric heating unit 200. As another example, the processor 101 may block the power supplied to the dielectric heating unit 200 when no puffs are sensed for a certain period of time.

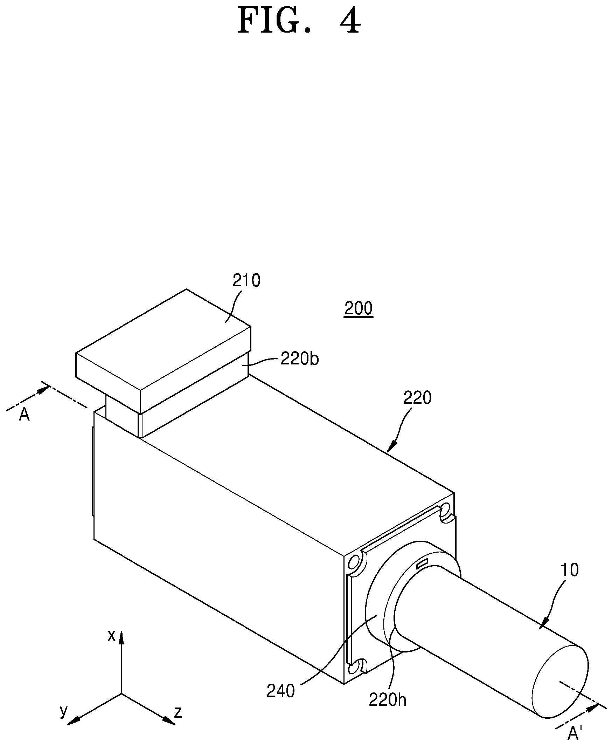

The insertion detection sensor may be arranged inside or adjacent to an accommodation space (220h of FIG. 4) and thus may detect the insertion and removal of the aerosol generating article 10 accommodated in the accommodation space 110h. For example, the insertion detection sensor may include an inductive sensor and/or a capacitance sensor. When the aerosol generating article 10 is inserted into the accommodation space 110h, the processor 101 may supply power to the dielectric heating unit 200.

According to an embodiment, the sensor unit 104 may additionally include a reuse detection sensor, a motion detection sensor, a humidity sensor, a barometric pressure sensor, a magnetic sensor, a cover detachment detection sensor, a location sensor (a global positioning system (GPS)), a proximity sensor, and the like. Because a function of each of sensors may be intuitively inferred from the name of the sensor, a detailed description thereof may be omitted.

The communication unit 105 may include at least one communication module for communication with external electronic device. The processor 101 may control the communication unit 105 and transmit information regarding the aerosol generating device 100 to the external electronic device. Alternatively, the processor 101 may receive information from the external electronic device through the communication unit 105 and control the components included in the aerosol generating device 100. For example, information exchanged between the communication unit 105 and the external electronic device may include user authentication information, firmware update information, and user's smoking pattern information.

The memory 106 may be a hardware component that stores various types of data processed in the aerosol generating device 100 and may store data processed and data to be processed by the processor 101. For example, the memory 106 may store an operation time of the aerosol generating device 100, the maximum number of puffs, the current number of puffs, at least one temperature profile, data on a user's smoking pattern, etc.

The battery 107 may supply power to the dielectric heating unit 200 to heat the aerosol generating article 10. In addition, the battery 107 may supply power required for operations of other components included in the aerosol generating device 100. The battery 107 may be a rechargeable battery or a separable and detachable battery.

The interface unit 108 may include a connection terminal that may be physically connected to the external electronic device. The connection terminal may include at least one of a High-Definition Multimedia Interface (HDMI) connector, a Universal Serial Bus (USB) connector, a Secure Digital (SD) card connector, and an audio connector (e.g., a headphone connector) or a combination thereof. The interface unit 108 may exchange information with the external electronic device through the connection terminal or charge power.

The power converter 109 may convert direct current power from the battery 107 into alternating current power. In addition, the power converter 109 may supply the converted alternating current power to the dielectric heating unit 200. The power converter 109 may be an inverter including at least one switching device, and the processor 101 may control the ON/OFF state of the switching device included in the power converter 109 and convert direct current power into alternating current power. The power converter 109 may be implemented as a full bridge or a half bridge.

The dielectric heating unit 200 may heat the aerosol generating article 10 by using a dielectric heating method. The dielectric heating unit 200 may correspond to the heater assembly 200 of FIG. 1.

The dielectric heating unit 200 may use microwaves and/or an electric field of microwaves (hereinafter, referred to as microwaves or microwave power when no classification is required) to heat the aerosol generating article 10. The heating method of the dielectric heating unit 200 may include heating a heating object by producing microwaves in a resonance structure, rather than radiating microwaves by using an antenna. The resonance structure is described below with reference to FIGS. 4 and subsequent figures.

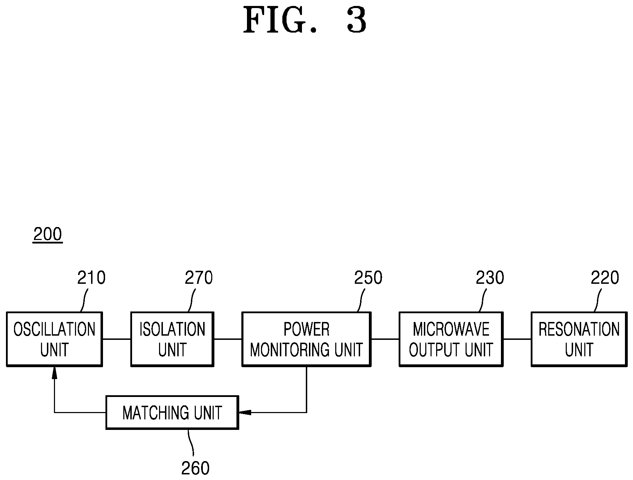

The dielectric heating unit 200 may output high-frequency microwaves to a resonating unit (220 of FIG. 3). Microwaves may be power in an Industrial Scientific and Medical (ISM) band allowed for heating, but one or more embodiments are not limited thereto. The resonating unit 220 may be designed by taking the wavelength of the microwaves into account to facilitate the resonance of the microwaves within the resonating unit 220.

The aerosol generating article 10 may be inserted into the resonating unit 220, and a dielectric material in the aerosol generating article 10 may be heated by the resonating unit 220. For example, the aerosol generating article 10 may include a polar substance, and molecules in the polar substance may be polarized in the resonating unit 220. The molecules may vibrate or rotate due to polarization, and the aerosol generating article 10 may be heated by frictional heat generated during the vibration or rotation. The dielectric heating unit 200 is described in more detail with reference to FIG. 3.

The processor 101 may control general operations of the aerosol generating device 100. The processor 101 may be implemented as an array of a plurality of logic gates or as a combination of a general-purpose microprocessor and a memory in which a program executable in the microprocessor is stored. Also, the processor 101 may be implemented in other forms of hardware.

The processor 101 may control direct current power supplied from the battery 107 to the power converter 109 and/or alternating current power supplied from the power converter 109 to the dielectric heating unit 200, according to power required for the dielectric heating unit 200. In an embodiment, the aerosol generating device 100 may include a converter that increases or decreases direct current power, and the processor 101 may control the converter to adjust the magnitude of the direct current power. Additionally, the processor 101 may adjust a switching frequency and a duty ratio of the switching device included in the power converter 109, thus controlling the alternating current power supplied to the dielectric heating unit 200.

The processor 101 may control microwave power of the dielectric heating unit 200 and a resonance frequency of the dielectric heating unit 200, thereby controlling a heating temperature of the aerosol generating article 10. Therefore, an oscillating unit 210, an isolation unit 270, a power monitoring unit 250, and a matching unit 260 of FIG. 3 described below may be some components of the processor 101.

The processor 101 may control microwave power of the dielectric heating unit 200 based on temperature profile information stored in the memory 106. In other words, a temperature profile may include information regarding a target temperature of the dielectric heating unit 200 over time, and the processor 101 may control the microwave power of the dielectric heating unit 200 over time.

The processor 101 may adjust the frequency of the microwaves to make the resonance frequency of the dielectric heating unit 200 uniform. The processor 101 may track a change in the resonance frequency of the dielectric heating unit 200 in real time as the heating object is heated, and may control the dielectric heating unit 200 to output a microwave frequency according to the changing resonance frequency. In other words, the processor 101 may adjust the microwave frequency in real time, irrespective of the temperature profile stored in advance.

FIG. 3 is an internal block diagram of the dielectric heating unit of FIG. 2.

Referring to FIG. 3, the dielectric heating unit 200 may include the oscillating unit 210, the isolation unit 270, the power monitoring unit 250, the matching unit 260, a microwave output unit 230, and the resonating unit 220. However, components of the dielectric heating unit 200 are not limited to that illustrated in Fig. 3. Depending on design of the dielectric heating unit 200, some of the components illustrated in Fig. 3 may be omitted or new component may be added.

The oscillating unit 210 may receive alternating current power from the power converter 109 and generate high-frequency microwave power. According to an embodiment, the power converter 109 may be included in the oscillating unit 210. Microwave power may be selected from the frequency bands, such as 915 MHz, 2.45 GHz, and 5.8 GHz, which are included in the ISM bands.

The oscillating unit 210 may include a solid-state-based RF generating device and generate microwave power by using the same. The solid-state-based RF generating device may be realized as a semiconductor. When the oscillating unit 210 is implemented as a semiconductor, the dielectric heating unit 200 may be miniaturized, and the lifespan of the device may be extended.

The oscillating unit 210 may output microwave power to the resonating unit 220. The oscillating unit 210 may include a power amplifier that increases or decreases the microwave power, and the power amplifier may adjust the magnitude of the microwave power under the control by the processor 101. For example, the power amplifier may decrease or increase the amplitude of microwaves. As the amplitude of microwaves is adjusted, the microwave power may also be adjusted.

The processor 101 may adjust the magnitude of the microwave power output from the oscillating unit 210, based on the temperature profile stored in advance. For example, the temperature profile may include target temperature information according to the preheating section and the smoking section, and the oscillating unit 210 may supply microwave power at a first power level in the preheating section and supply microwave power at a second power level in the smoking section, wherein the second power level is less than the first power level.

The isolation unit 270 may block the microwave power that is input to the oscillating unit 210 from the resonating unit 220. Most of the microwave power that is output from the oscillating unit 210 is absorbed into the heating object, but depending on the heating characteristics of the heating object, part of the microwave power may be reflected from the heating object and transmitted back towards the oscillating unit 210. This occurs due to a change in the impedance measured from the oscillating unit 210 to the resonating unit 220 as polar molecules are depleted while the heating object is heated. The description that 'the impedance from the oscillating unit 210 to the resonating unit 220 changes' may be the same as the description that 'the resonance frequency of the resonating unit 220 changes.' When the microwave power reflected from the resonating unit 220 is input to the oscillating unit 210, the oscillating unit 210 may not only malfunction but also fail to achieve expected output performance. The isolation unit 270 may not redirect the microwave power, which is reflected from the resonating unit 220, to the oscillating unit 210 and may guide the microwave power in a certain direction to absorb the same. To this end, the isolation unit 270 may include a circulator and a dummy load.

The power monitoring unit 250 may monitor the microwave power, which is output from the oscillating unit 210, and the reflected microwave power, which is reflected from the resonating unit 220, respectively. The power monitoring unit 250 may transmit information regarding the microwave power and the reflected microwave power to the matching unit 260.

The matching unit 260 may match the impedance measured from the oscillating unit 210 to the resonating unit 220 with the impedance measured from the resonating unit 220 to the oscillating unit 210 to minimize the reflected microwave power. Impedance matching may indicate that the frequency of the oscillating unit 210 aligns with the resonance frequency of the resonating unit 220. Therefore, the matching unit 260 may vary the frequency of the oscillating unit 210 to match the impedance. In other words, the matching unit 260 may adjust the frequency of the microwave power that is output from the oscillating unit 210 to minimize the reflected microwave power. The impedance matching by the matching unit 260 may be performed in real time regardless of the temperature profile.

The oscillating unit 210, the isolation unit 270, the power monitoring unit 250, and the matching unit 260 described above may be distinct from the microwave output unit 230 and the resonating unit 220 below and may be implemented as microwave sources in the form of chips. According to an embodiment, the oscillating unit 210, the isolation unit 270, the power monitoring unit 250, and the matching unit 260 may be implemented as some components of the processor 101.

The microwave output unit 230 may be a component configured to input the microwave power to the resonating unit 220 and may correspond to a coupler shown in FIG. 3 and subsequent figures. The microwave output unit 230 may be implemented in the form of SubMiniature version A (SMA), SubMiniature version B (SMB), Micro Coaxial (MCX), and Micro-Miniature coaxial (MMCX) connectors. The microwave output unit 230 may connect the resonating unit 220 to a chip-shaped microwave source and deliver microwave power generated from the microwave source to the resonating unit 220.

The resonating unit 220 may form microwaves within the resonance structure, thus heating the heating object. The resonating unit 220 may include an accommodation space where the aerosol generating article 10 is accommodated, and the aerosol generating article 10 may be exposed to microwaves and dielectric-heated. For example, the aerosol generating article 10 may include a polar substance, and molecules in the polar substance may be polarized by the microwaves within the resonating unit 220. The molecules may vibrate or rotate due to polarization, and the aerosol generating article 10 may be heated by frictional heat generated during the vibration or rotation.

The resonating unit 220 may include at least one internal conductor to resonate microwaves, and depending on the arrangement, thickness, length, and the like of the internal conductor, the microwaves may resonate within the resonating unit 220.

The resonating unit 220 may be designed by taking the wavelength of the microwaves into account to facilitate the resonance of the microwaves within the resonating unit 220.. For the resonance of the microwaves within the resonating unit 220, there is a need for a closed end/short end with a closed cross-section and an open end with at least one open portion on the opposite side. In addition, the length between the closed end/short end and the open end must be set to an integer multiple of 1/4 of the microwave wavelength. The resonating unit 220 selects a length equal to 1/4 of the microwave wavelength to ensure device miniaturization. In other words, the length between the closed end/short end and the open end of the resonating unit 220 may be set to 1/4 of the microwave wavelength.

The resonating unit 220 may include a dielectric accommodation space. The dielectric accommodation space is separate from the accommodation space of the aerosol generating article 10 and contains a material that may reduce the size of the resonating unit 220 by changing the overall resonance frequency of the resonating unit 220. In an embodiment, dielectric materials with low microwave absorption may be accommodated in the dielectric accommodation space. Such accommodation is intended to prevent energy, which should be delivered to the heating object, from being transferred to the dielectric materials and causing the dielectric materials to generate heat. Microwave absorbance may be expressed as a loss tangent that is a ratio of a real part of a complex dielectric constant to an imaginary part thereof. In an embodiment, dielectric materials with a loss tangent of a preset value or less may be accommodated in the dielectric accommodation space 227, and the preset value may be 1/100. For example, the dielectric material may include at least any one of quartz, tetrafluoroethylene, and aluminum oxide, or a combination thereof, but one or more embodiments are not limited thereto.

FIG. 4 is a perspective view of a heater assembly according to an embodiment.

Referring to FIG. 4, the heater assembly 200 according to an embodiment may include the oscillating unit 210 and the resonating unit 220. FIG. 4 may show an embodiment of the heater assembly 200 and the dielectric heating unit 200 described above, and repeated description is omitted.

The oscillating unit 210 may generate microwaves in a designated frequency band as power is supplied. The microwaves generated by the oscillating unit 210 may be transferred to the resonating unit 220 through a coupler (not shown).

The heater assembly 200 according to an embodiment may further include an accommodation space 220h in which the aerosol generating article 10 is accommodated and a support 240 capable of supporting the aerosol generating article 10 accommodated in or inserted into the accommodation space 220h.

The heater assembly 200 may include the accommodation space 220h for accommodating the aerosol generating article 10 therein, and one area of the aerosol generating article 10 may be inserted into the resonance unit 220 through the accommodation space 220h. Another area of the aerosol generating article 10 spaced apart from the one area of the aerosol generating article 10 may be exposed to the outside of the resonance unit 220. A portion of the other area of the aerosol generating article 10 exposed to the outside of the resonance unit 220 may be supported by the support 240.

The aerosol generating article 10 accommodated in or inserted into the accommodation space 220h may resonate microwaves generated by the oscillation unit 210 so as to be heated by using the dielectric heating method. For example, charges of glycerin included in the aerosol generating article 10 may vibrate or rotate due to the resonance of the microwaves, and frictional heat generated during such vibration or rotation may cause heat to be produced in the glycerin such that aerosol generating article 10 may be heated.

According to an embodiment, the resonating unit 220 may include a material with low microwave absorption to prevent the microwaves, generated by the oscillating unit 210, from being absorbed into the resonating unit 220.

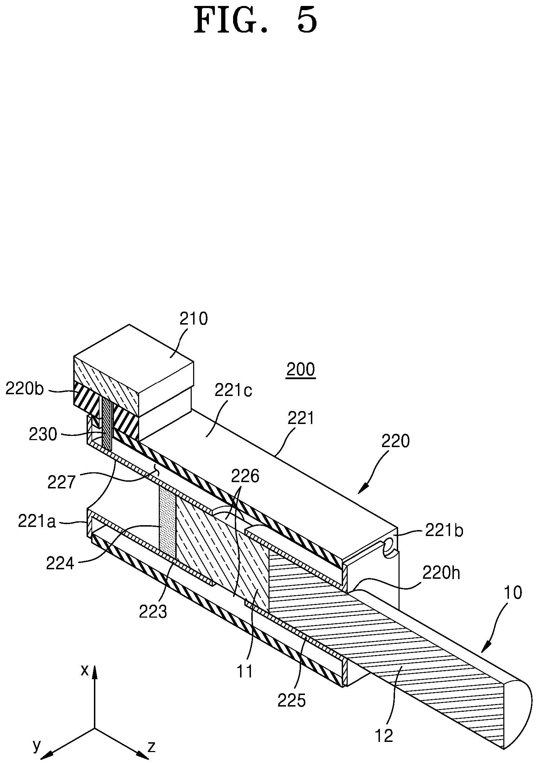

Hereinafter, the detailed structure of the resonating unit 220 of the heater assembly 200 is described with reference to FIG. 5.

FIG. 5 is a cross-sectional view of the heater assembly of FIG. 4. FIG. 5 shows a cross-section of the heater assembly 200 of FIG. 4, taken along a direction A-A'.

Referring to FIG. 5, the heater assembly 200 according to an embodiment may include the oscillating unit 210, the resonating unit 220, and a coupler 230. The components of the heater assembly 200 may be the same as or similar to at least one of the components of the heater assembly 200 of FIG. 4, and repeated description is omitted hereinafter.

The oscillating unit 210 may generate microwaves in a designated frequency band as an alternating current voltage is applied, and the microwaves generated by the oscillating unit 210 may be delivered to the resonating unit 220 through the coupler 230.

According to an embodiment, the oscillating unit 210 may be fixed to the resonating unit 220 to prevent separation from the resonating unit 220 while the aerosol generating device is used. In an embodiment, the oscillating unit 210 may be supported by brackets 220b protruding along the x direction on a portion of the resonating unit 220, thus being fixed to the resonating unit 220. In another embodiment, the oscillating unit 210 may be fixed to a portion of the resonating unit 220 without the brackets 220b.

In the drawing, the oscillating unit 210 is fixed to a portion of the resonating unit 220 that faces the x direction, but the position of the oscillating unit 210 is not limited thereto. In another embodiment, the oscillating unit 210 may be fixed to another portion of the resonating unit 220 that faces in the -z direction.

The resonating unit 220 may be arranged to surround at least a portion of the aerosol generating article 10 inserted into the aerosol generating device and may heat the aerosol generating article 10 by using the microwaves generated by the oscillating unit 210. For example, dielectric materials included in the aerosol generating article 10 may generate heat because of the electric field generated in the resonating unit 220 due to the microwaves, and the aerosol generating article 10 may be heated by the heat generated in the dielectric materials.

According to an embodiment, the aerosol generating article 10 may include a tobacco rod 11 and a filter rod 12.

The tobacco rod 11 may include an aerosol generating material and may be formed as a sheet, a strand, or a pipe tobacco formed of tiny bits cut from a tobacco sheet. For example, the aerosol generating material may include at least one of glycerin, propylene glycol, ethylene glycol, dipropylene glycol, diethylene glycol, triethylene glycol, tetraethylene glycol, and oleyl alcohol, but it is not limited thereto. Also, the tobacco rod 11 may include other additives, such as flavors, a wetting agent, and/or organic acid. Also, the tobacco rod 11 may include a flavored liquid, such as menthol or a moisturizer, which is injected to the tobacco rod 11.

The filter rod 12 may include a cellulose acetate filter. Shapes of the filter rod 12 are not limited. For example, the filter rod 12 may include a cylinder-type rod or a tube-type rod having a hollow inside. Also, the filter rod 12 may include a recess-type rod. When the filter rod 12 includes a plurality of segments, at least one of the plurality of segments may have a different shape.

At least part (e.g., glycerin) of the aerosol generating material included in the aerosol generating article 10 may be a dielectric material with polarity in an electric field, and the at least part of the aerosol generating material may generate heat in a dielectric heating method, thereby heating the aerosol generating article 10.

According to an embodiment, the resonating unit 220 may include an outer conductor 221, a first internal conductor 223, and a second internal conductor 225.

The outer conductor 221 may form the overall exterior of the resonating unit 220 and have a shape with a hollow space therein; thus, the components of the resonating unit 220 may be arranged inside the outer conductor 221. The outer conductor 221 may include the accommodation space 220h where the aerosol generating article 10 may be accommodated, and the aerosol generating article 10 may be inserted into the outer conductor 221 through the accommodation space 220h.

According to an embodiment, the outer conductor 221 may include a first surface 221a, a second surface 221b facing the first surface 221a, and side surfaces 221c surrounding an empty space between the first surface 221a and the second surface 221b. At least a portion (e.g., the first internal conductor 223 and the second internal conductor 225) of the components of the resonating unit 220 may be arranged in the inner space of the resonating unit 220 formed by the first surface 221a, the second surface 221b, and the side surfaces 221c.

The first internal conductor 223 may be shaped as a hollow cylinder extending in a direction towards the inner space of the outer conductor 221 from the first surface 221a of the outer conductor 221.

According to an embodiment, a portion of the first internal conductor 223 may contact the coupler 230 connected to the oscillating unit 210, and the microwaves generated by the oscillating unit 210 may be transferred to the first internal conductor 223 through the coupler 230. For example, the coupler 230 may penetrate the outer conductor 221 and may be arranged so that one end of the coupler 230 contacts the oscillating unit 210 and the other end contacts a portion of the first internal conductor 223, and the microwaves generated by the oscillating unit 210 may be transferred to the first internal conductor 223 through the coupler 230.

In this case, the coupler 230 may be arranged not to contact the outer conductor 221 but to penetrate the same to transfer the microwaves, but the arrangement of the coupler 230 is not limited thereto as long as the microwaves generated by the oscillating unit 210 may be delivered to the first internal conductor 223.

A first area formed between the outer conductor 221 and the first internal conductor 223 may function as a 'first resonator' that generates an electric field through microwave resonance. The first area may refer to the space formed by the first surface 221a and the side surfaces 221c of the outer conductor 221 and the first internal conductor 223, and within the first area, an electric field may be generated as the microwaves transmitted through the coupler 230 resonate.

The second internal conductor 225 may be shaped as a hollow cylinder extending in a direction towards the inner space of the outer conductor 221 from the second surface 221b of the outer conductor 221. The second internal conductor 225 may be spaced apart from the first internal conductor 223 by a certain distance within the inner space of the outer conductor 221, and there may be a gap between the first internal conductor 223 and the second internal conductor 225.

A second area formed between the outer conductor 221 and the second internal conductor 225 may function as a 'second resonator' that generates an electric field through microwave resonance. The second internal conductor 225 may be coupled to the first internal conductor 223 (e.g., capacitive coupling), and when an electric field is generated in the first area because of the above coupling relationship, an induced electric field may be generated even in the second area. In the present specification, the term 'capacitive coupling' may refer to a coupling relationship in which energy may be transferred due to capacitance between two conductors.

For example, as the microwaves generated by the oscillating unit 210 are delivered to the first internal conductor 223, an electric field may be generated in the first area due to resonance, and an induced electric field may be generated in the second area that is formed by the second internal conductor 225 coupled to the outer conductor 221 and the first internal conductor 223.

According to an embodiment, the first area and the second area of the resonating unit 220 may operate as resonators with a length equal to a quarter of the microwave wavelength λ.

In an embodiment, one end of the first area (e.g., an end in the -z direction) may be formed as a closed end/short end as the cross-section of the first area is closed by the first surface 221a of the outer conductor 221, and the other end of the first area (e.g., an end in the z direction) may be formed as an open end because the first surface 221a is not present, leaving the cross-section open. As another example, one end of the second area (e.g., an end in the -z direction) may be formed as an open end as the cross-section is open, and the other end of the second area (e.g., an end in the z direction) may be formed as a closed end/short end as the cross-section of the second area is closed by the second surface 221b of the outer conductor 221.

In other words, when viewed in an xz plane, the first area and the second area may each include a closed end/short end and an open end and may be shaped overall in the form of "⊏", and based on the above-described structure, the first area and the second area may each function as a resonator with a length of a quarter of the microwave wavelength.

According to an embodiment, the first internal conductor 223 and the second internal conductor 225 are formed to have the same length with respect to the z axis, and thus, the first area and the second area may be symmetrically arranged; however, one or more embodiments are not limited thereto.

Depending on the resonance structure of the resonance unit 220 described above, an electric field may not be transmitted in an external area of the resonance unit 220 in which a conductor, such as a first internal conductor 223 and a second internal conductor 225, are not present. Therefore, even when a separate shielding member for shielding an electric field is not present, the heater assembly 200 may prevent the electric field from leaking out of the heater assembly 200.

The heat dissipation member may be located inside the resonance unit 220 and may absorb heat inside the resonance unit 220. For example, the heat dissipation member may be located inside the first internal conductor 223 and may be arranged in contact with one surface of a closure unit 224.

The heat dissipation member may take away the heat generated in the heater assembly 200 and emit the heat to the surroundings of the heat dissipation member. For example, the heat dissipation member may sink the heat which is emitted to the outside of the resonance unit 220, and emit the sunk heat toward a medium with a relatively low temperature (e.g., the aerosol generating article 10). The heater assembly 200 according to an embodiment may emit the heat generated in the heater assembly 200 to the outside of the heater assembly 200 through the heat dissipation member described above.

The aerosol generating article 10 inserted into an internal space of an outer conductor 221 through the accommodation space 220h may be surrounded by the first internal conductor 223 and the second internal conductor 225 and heated by using the dielectric heating method. For example, a portion of the aerosol generating article 10 inserted into the internal space of the outer conductor 221 may be arranged inside the first internal conductor 223 and the second internal conductor 225, and another portion of the aerosol generating article 10 may be arranged outside the first internal conductor 223 and the second internal conductor 225. Due to an electric field generated inside and outside of the first internal conductor 223 and/or the second internal conductor 225, a dielectric included in the aerosol generating article 10 may generate heat so that the aerosol generating article 10 may be heated.

According to an embodiment, when the aerosol generating article 10 is inserted into the resonance unit 220 through the accommodation space 220h, a tobacco rod 11 of the aerosol generating article 10 may be arranged at a location corresponding to a gap 226 between the first internal conductor 223 and the second internal conductor 225.

A resonance peak may be formed at an end of the first internal conductor 223 operating as a first resonator and an end of the second internal conductor 225 operating as a second resonator, so that a stronger electric field may be generated compared to other areas. As a result, a strongest electric field may be generated in the gap 226 between the first internal conductor 223 and the second internal conductor 225 within the inner area of the resonance unit 220. In the heater assembly 200 according to an embodiment, the tobacco rod 11 including a dielectric field which generates heat due to an electric field may be arranged at a location corresponding to the gap 226 with the strongest electric field, thereby improving heating efficiency (or "dielectric heating efficiency") of the heater assembly 200.

According to an embodiment, the resonance unit 220 may further include a dielectric accommodation space 227 for accommodating a dielectric therein. The dielectric accommodation space 227 may be formed in an empty space between the outer conductor 221 and the first internal conductor 223 and the second internal conductor 225, and a dielectric with a low microwave absorptivity may be accommodated in the dielectric accommodation space 227. For example, a dielectric may be at least one of quartz, tetrafluoroethylene, or aluminum oxide, or a combination thereof, but the disclosure is not limited thereto.

In the heater assembly 200 according to an embodiment, a dielectric may be arranged inside the dielectric accommodation space 227 so that an overall size of the resonance unit 220 may be reduced while generating the same electric field as the resonance unit 220 which does not include a dielectric. In other words, in the heater assembly 200 according to an embodiment, due to the dielectric arranged inside the dielectric accommodation space 227, the size of the resonance unit 220 may be reduced so that a mounting space of the resonance unit 220 within the aerosol generating device may also be reduced, and as a result, the aerosol generating device may become more compact.

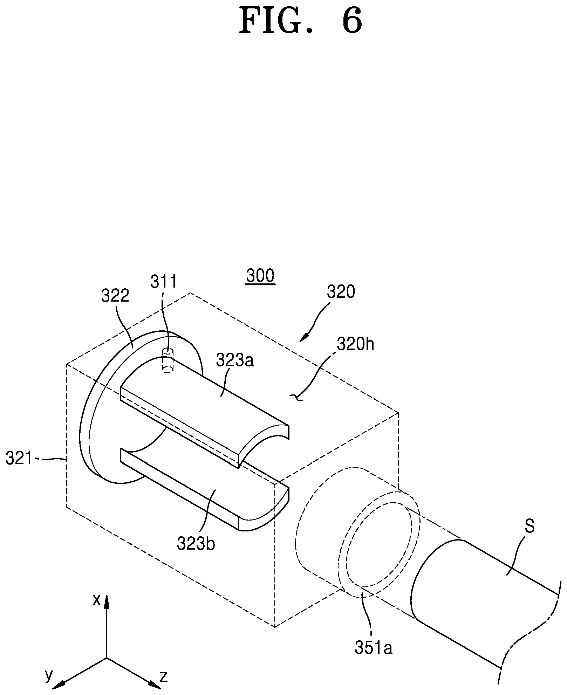

FIG. 6 is a perspective view of a heater assembly according to another embodiment.

Referring to FIG. 6, a heater assembly 300 according to another embodiment may include a resonance unit 320 and a coupler 311. Elements of the heater assembly 300 may be identical or similar to at least one of the elements of the heater assembly 200 of FIGS. 4 and 5, and redundant descriptions thereof are omitted below.

The resonance unit 320 may include an outer conductor 321, a plurality of first internal conductors 323a and 323b, and a closure unit 322.

The coupler 311 may supply microwaves to at least one of the plurality of first internal conductors 323a and 323b so that microwave resonance is generated in the resonance unit 320.

The outer conductor 321 may form the overall exterior of the resonance unit 320, and the interior may be formed in a hollow shape so that elements of the resonance unit 320 may be arranged inside the outer conductor 321. For example, overall, the outer conductor 321 may be formed as a square column having a square cross-section, but the disclosure is not limited thereto. In another example, the outer conductor 321 may be formed as a polygonal column having a rectangular, elliptical, or circular cross-section.

The outer conductor 321 may include an accommodation space 320h in which the aerosol generating article 10 may be accommodated and a support 351a which is inserted into the accommodation space 320h to support the aerosol generating article 10. One area of the aerosol generating article 10 may be inserted into the outer conductor 321 through the accommodation space 320h, and another area of the aerosol generating article 10 may be exposed to the outside of the resonance unit 320. The support 351a may support the other area of the aerosol generating article 10 exposed to the outside of the resonance unit 320.

The outer conductor 321 may include a first surface 321a, a second surface 321b arranged to face the first surface 321a, and a side surface 321c surrounding an empty space between the first surface 321a and the second surface 321b. At least some (e.g., the first internal conductors 323a and 323b) of the elements of the resonance unit 320 may be arranged in the internal space of the resonance unit 320 which is formed by the first surface 321a, the second surface 321b, and the side surface 321c.

The plurality of first internal conductors 323a and 323b may be formed in a plate shape which extends in a direction toward an internal space of the outer conductor 321 from the first surface 321a of the outer conductor 321. For example, the plurality of first internal conductors 323a and 323b may be spaced apart from each other along the perimeter of the aerosol generating article 10 accommodated in the accommodation space 320h, one (e.g., the first internal conductor 323a) of the plurality of first internal conductors 323a and 323b may be arranged to surround one area of the aerosol generating article 10, and the other one (e.g., the first internal conductor 323b) may be surround another area of the aerosol generating article 10.

One of the first internal conductor 323a may be in contact with the coupler 311 which is connected to an oscillation unit, and with the resonation of microwaves transferred through the coupler 311, an electric field may be generated inside the plurality of first internal conductors 323a and 323b. For example, the coupler 311 may pass through the outer conductor 321 and have one end in contact with the oscillation unit and the other end in contact with one area of the first internal conductor 323a, and following the transfer of microwaves generated in the oscillation unit to the first internal conductor 323a through the coupler 311, an electric field may be generated inside the plurality of first internal conductors 323a and 323b.

The resonance unit 320 may include a short end having a cross-section closed to have a length (λ/4) of 1/4 of a wavelength (λ) of microwaves, and an open end which is positioned in the opposite direction to the short end and has a cross-section with at least one opened area.

The resonance unit 320 may include the closure unit 322 which is arranged in contact with one end of the plurality of first internal conductors 323a and 323b and closes cross-sections of the plurality of first internal conductors 323a and 323b. Due to the closure unit 322, a cross-section of one end of the plurality of first internal conductors 323a and 323b may be closed so that a short end may be formed at one end of the plurality of first internal conductors 323a and 323b. The other ends of the plurality of first internal conductors 323a and 323b are spaced apart from the closure unit 322 so as not to come into contact with the closure unit 322. Thus, an open end may be formed at the other end of the plurality of first internal conductors 323a and 323b. In other words, when viewed on an xz plane, the plurality of first internal conductors 323a and 323b may be formed in an overall " 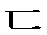 " shape and may include a short end and an open end, and according to the above-described structure of the plurality of first internal conductors 323a and 323b, the plurality of first internal conductors 323a and 323b may operate as a resonator having a 1/4-wavelength of microwaves.

Microwave resonance may be formed between the first internal conductor 323a and an outer conductor 331, between another first internal conductor 323b and the outer conductor 331, and between the first internal conductor 323a and another first internal conductor 323b. Accordingly, an electric field may also be generated between the first internal conductors 323a and 323b and the outer conductor 321. In the drawings, two first internal conductors 323a and 323b. However, the disclosure is not limited thereto, and in another example, the number of the plurality of first internal conductors may be three, four, or more.

A triple resonance mode may be formed inside the resonance unit 320. For example, of a transverse electric & magnetic (TEM) mode of microwaves may be formed inside the plurality of first internal conductors 323a and 323b, and resonance of the TEM mode that is different from the resonance formed inside the plurality of first internal conductors 323a and 323b may be formed between the first internal conductor 323a and the outer conductor 321 and between the first internal conductor 323b and the outer conductor 321. With the triple resonance mode formed inside the resonance unit 320, the aerosol generating article 10 accommodated in the resonance unit 320 may be heated more uniformly.

According to the resonance structure of the resonance unit 320 described above, an electric field may not be transmitted to an external area of the resonance unit 320. Therefore, leakage of an electrical field to the outside of the heater assembly 300 may be prevented even when the heater assembly 300 does not have an additional shielding member for shielding the electric field.

A resonance peak may be formed at the other end of the plurality of first internal conductors 323a and 323b so that a stronger electric field may be generated compared to other areas, and the tobacco rod 11 which includes a dielectric capable of generating heat by using an electric field may be arranged at a position corresponding to an area with the strongest electric field. Thereby, the heating efficiency (or "dielectric heating efficiency" of the heater assembly 300 may be improved.

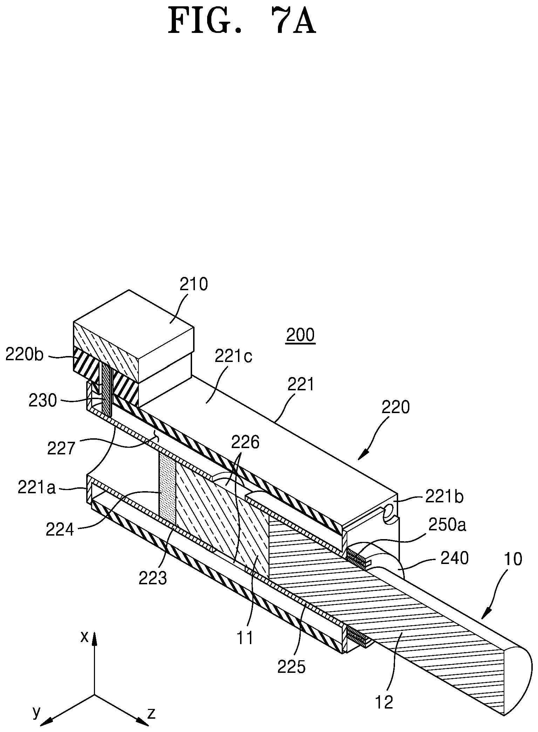

Below, a sensor for detecting insertion of a metal into an accommodation space 330h is discussed in detail with reference to FIGS. 7A to 7D.

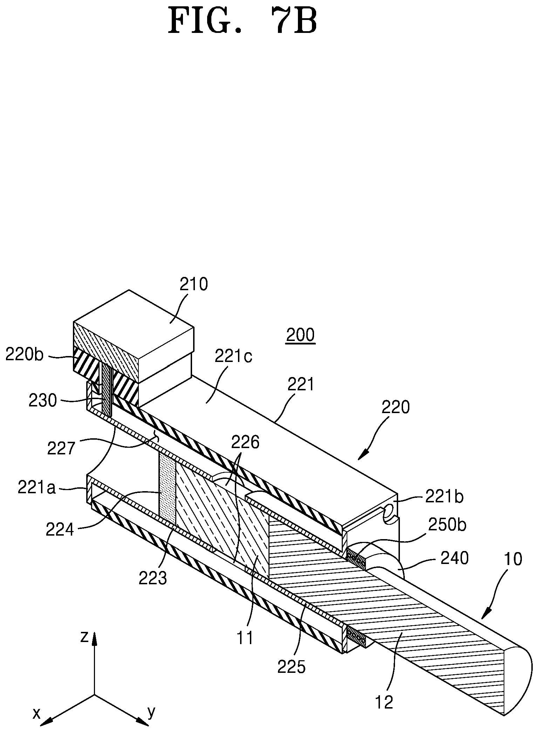

FIG. 7A is a diagram for describing an example of a sensor provided in a heater assembly according to an embodiment, and FIG. 7B is a diagram for describing another example of a sensor provided in a heater assembly according to an embodiment. FIGS. 7A and 7B show a cross-section of the heater assembly 200 of FIG. 4, taken along line A-A'.

Referring to FIGS. 7A and 7B, the heater assembly 200 according to an embodiment may include the oscillation unit 210 (e.g., the oscillation unit 210 of FIGS. 4 and 5), a resonance unit 230 (e.g., the resonance unit 230 of FIGS. 4 and 5), and a sensor 250a or 250b. At least one of elements of the heater assembly 200 of FIGS. 7A and 7B are identical or similar to the elements of the heater assembly 200 of FIGS. 4 and 5, and redundant descriptions thereof are omitted in the description below.

The oscillation unit 210 may generate microwaves in a designated frequency band with the application of alternating current voltage, and the microwaves generated in the resonance unit 220 may be delivered to the resonance unit 220 through the coupler 230.

The resonance unit 220 may be arranged to surround at least one area of the aerosol generating article 10 inserted into an aerosol generating device (e.g., the aerosol generating device 100 of FIG. 1), and the aerosol generating article 10 may be heated through the microwaves generated in the oscillation unit 210. For example, dielectrics included the aerosol generating article 10 may generate heat by an electric field generated inside the resonance unit 220 due to resonance of microwaves, and the aerosol generating article 10 may be heated by the heat generated in the dielectrics.

According to an embodiment, the resonance unit 220 may include the outer conductor 221, the first internal conductor 223, and the second internal conductor 225.

The outer conductor 221 may form the overall exterior of the resonance unit 220, and the interior of the outer conductor 221 may be formed in a hollow shape so that the elements of the resonance unit 220 may be arranged inside the outer conductor 221. The outer conductor 221 may include the accommodation space 220h through which at least one area of the aerosol generating article 10 may be inserted into the outer conductor 221. The accommodation space 220h the accommodation space 220h may refer to a space formed by the first internal conductor 223 and/or the second internal conductor 225 arranged inside the outer conductor 221 to accommodate the aerosol generating article 10 inserted into the outer conductor 221.

According to an embodiment, the outer conductor 221 may include a first surface 231a, a second surface 231b arranged to face the first surface 231a, and a side surface 231c surrounding an empty space between the first surface 231a and the second surface 231b. At least some (e.g., the first internal conductor 223 and the second internal conductor 225) of the elements of the resonance unit 220 may be arranged in the internal space of the resonance unit 220 formed by the first surface 231a, the second surface 231b, and the side surface 231c.

The first internal conductor 223 may be formed in a hollow cylindrical shape which extends in a direction toward the internal space of the outer conductor 221 from the first surface 231a of the outer conductor 221, or in a length direction of the outer conductor 221.

According to an embodiment, one area of the first internal conductor 223 may be in contact with the coupler 230 connected to the oscillation unit 210, and microwaves generated in the oscillation unit 210 may be transferred to the first internal conductor 223 through the coupler 230. For example, the coupler 230 may pass through the outer conductor 221 and may have one end in contact with the oscillation unit 210 and the other end in contact with one area of the first internal conductor 223, and microwaves generated in the oscillation unit 210 may be transferred to the first internal conductor 223 through the coupler 230.

In this case, the coupler 230 may be arranged to pass through the outer conductor 221 without being in contact with the outer conductor 221. However, the arrangement structure of the coupler 230 is not limited thereto, as long as the microwaves generated in the oscillation unit 210 are transferred to the first internal conductor 223.

A first area formed between the outer conductor 221 and the first internal conductor 223 may operate as a "first resonator" which generates an electric field through resonance of microwaves. The first area may refer to a space formed by a first surface 221a, a side surface 221c, and the first internal conductor 223, and within the first area, microwaves transferred through the coupler 230 may resonate so that an electric field may be generated.

A second area formed by the outer conductor 221 and the second internal conductor 225 may operate as a "second resonator" which generates an electric field through resonance of microwaves. The second internal conductor 225 may be coupled (e.g., capacitively coupled) to the first internal conductor 223, and when an electric field is generated within the first area by the coupling relationship described above, an induced electric field may also be generated within the second area. In the present disclosure, "capacitive coupling" may refer to a coupling relationship in which energy may be transferred by electrostatic capacity (capacitance) between two conductors.

For example, when the microwaves generated from the oscillation unit 210 are transferred to the first internal conductor 223, an electric field may be generated within the first area due to resonance, and an induced electric field may be generated within the second area formed by the second internal conductor 225 which is coupled to the outer conductor 221 and the first internal conductor 223.

The second internal conductor 225 may be formed in a hollow cylindrical shape which extends in a direction toward the internal space of the outer conductor 221 from the second surface 231b of the outer conductor 221, or in the length direction of the outer conductor 221. The second internal conductor 225 may be spaced apart from the first internal conductor 223 by a certain distance in the internal space of the outer conductor 221, and the gap 226 may be formed between the first internal conductor 223 and the second internal conductor 225.

The aerosol generating article 10 inserted into the internal space of the outer conductor 221 through the accommodation space 220h may be surrounded by the first internal conductor 223 and the second internal conductor 225 and heated by using the dielectric heating method. For example, a portion of the aerosol generating article 10 inserted into the internal space of the outer conductor 221 may be arranged inside the first internal conductor 223 and the second internal conductor 225, and another portion of the aerosol generating article 10 may be arranged outside the first internal conductor 223 and the second internal conductor 225. Due to an electric field generated inside and outside of the first internal conductor 223 and/or the second internal conductor 225, the dielectric included in the aerosol generating article 10 may generate heat so that the aerosol generating article 10 may be heated.

According to an embodiment, the resonance unit 220 may further include the dielectric accommodation space 227 and a dielectric accommodated in the dielectric accommodation space 227 to adjust permittivity of the resonance unit 220.

The dielectric accommodation space 227 may be formed in an empty space between the outer conductor 221 and the first internal conductor 223 and the second internal conductor 225, and the dielectric may be accommodated in the dielectric accommodation space 227. For example, the dielectric may be at least one of quartz, tetrafluoroethylene, and aluminum oxide, which have low microwave absorptivity, or a combination thereof, but types of the dielectric is not limited thereto.

In the heater assembly 200 according to another embodiment, the dielectric may be arranged inside the dielectric accommodation space 227 so that the overall size of the resonance unit 220 may be reduced while generating the same electric field as the resonance unit 220 which does not include a dielectric. In other words, in the heater assembly 200 according to another embodiment, due to the dielectric arranged inside the dielectric accommodation space 227, the size of the resonance unit 220 may be reduced so that a mounting space of the resonance unit 220 within the aerosol generating device may also be reduced, and as a result, the aerosol generating device (e.g., the aerosol generating device 100 of FIG. 1) may become more compact.

According to an embodiment, when the aerosol generating article 10 is inserted into the resonance unit 220 through the accommodation space 220h, the tobacco rod 11 of the aerosol generating article 10 may be arranged at the location corresponding to the gap 226 between the first internal conductor 223 and the second internal conductor 225.

A resonance peak may be formed at an end of the first internal conductor 223 operating as the first resonator and an end of the second internal conductor 225 operating as the second resonator, so that a stronger electric field may be generated compared to other areas. As a result, the strongest electric field may be generated in the gap 226 between the first internal conductor 223 and the second internal conductor 225 within the inner area of the resonance unit 220. Because the tobacco rod 11 including a dielectric generating heat by an electric field is arranged at a position corresponding to the gap 226 with the strongest electric field, the heating efficiency (or "dielectric heating efficiency") of the heater assembly 200 may be improved.

The sensors 250a and 250b may be coils for detecting insertion of a metal material (hereinafter, referred to as "metal") into an accommodation space 210h. The sensor 120 may be an inductance sensor for detecting a change in inductance within the accommodation space 220h, and the aerosol generating device 100 according to an embodiment may detect whether metal has been inserted into the accommodation space 220h, based on the change in inductance of the accommodation space 220h detected by the sensors 250a and 250b. For example, the processor 130 may detect a change in frequency corresponding to a change in inductance detected by the sensors 250a and 250b, and when it is determined that the detected change in frequency is greater than or equal to a preset frequency change, determine that a metal has been inserted into the accommodation space 220h.

The sensors 250a and 250b may be located outside the resonance unit 220 and may be arranged in one area adjacent to the accommodation space 220h. The sensors 250a and 250b may be located outside the resonance unit 220 so that the sensors 250a and 250b are not heated by the heater assembly 200 using the dielectric heating method.

For example, the sensors 250a and 250b may be arranged inside the support 240. The support 240 may be located outside the resonance unit 220 to surround an outer surface of the aerosol generating article 10 accommodated in or inserted into the accommodation space 220h. Accordingly, the sensors 250a and 250b may be located outside the resonance unit 220 to surround the outer surface of the aerosol generating article 10 accommodated in or inserted into the accommodation space 210h.

For example, the sensor 250a may be a plate-shaped coil which surrounds at least a portion of the outer surface of the aerosol generating article 10 inserted into the accommodation space 220h. In another example, the sensor 250b may be a ring-shaped coil which surrounds the outer surface of the aerosol generating article 10 inserted into the accommodation space 220h. Shapes of the sensors 250a and 250b are not limited to the examples described above.

In the drawings, only one sensor 250a or 250b is shown. However, the number of the sensors 250a and 250b are not limited thereto and may be two or three or more depending on the embodiment.

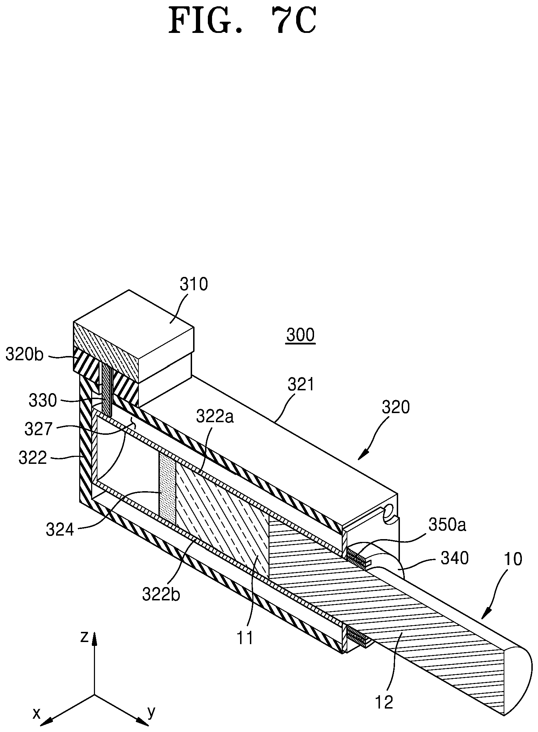

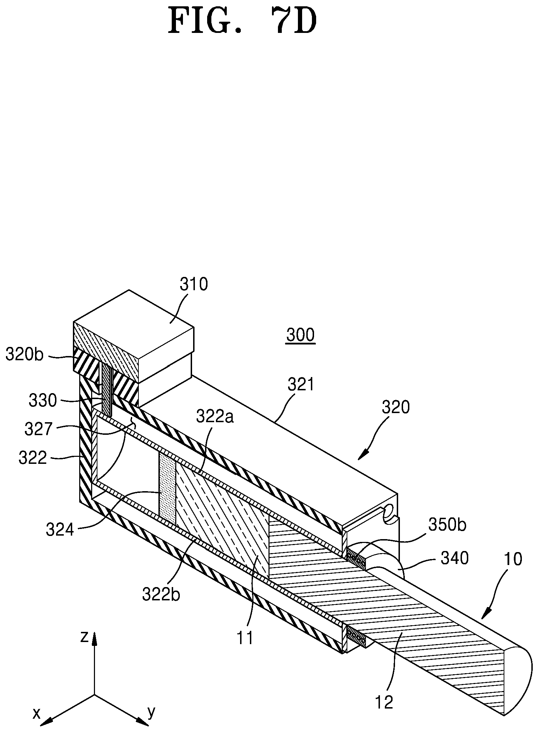

FIG. 7C is a diagram for describing an example of a sensor provided in a heater assembly according to another embodiment, and FIG. 7D is a diagram for describing another example of a sensor provided in a heater assembly according to another embodiment. FIGS. 7C and 7D show a cross-section of the heater assembly 300 of FIG. 6, taken along an xz plane.

Referring to FIGS. 7C and 7D, an oscillation unit (e.g., the oscillation unit 310 of FIG. 6) according to another embodiment, a resonation unit (e.g., the resonance unit 320 of FIG. 6), and the sensor 350a or 350b may be included. Elements of the heater assembly 300 of FIGS. 7C and 7D may be identical or similar to the heater assembly 300 of FIGS. 7A and 7B, and redundant descriptions thereof are omitted below.

The sensors 350a and 350b may be coils for detecting insertion of a metal material (hereinafter, referred to as "metal") into an accommodation space 210h. The sensor 120 may be an inductance sensor for detecting a change in inductance within the accommodation space 320h, and the aerosol generating device 100 according to an embodiment may detect whether metal has been inserted into the accommodation space 320h, based on the change in inductance of the accommodation space 320h detected by the sensors 350a and 350b. For example, the processor 130 may detect a change in frequency corresponding to a change in inductance detected by the sensors 350a and 350b, and when it is determined that the detected change in frequency is greater than or equal to a preset frequency change, determine that a metal has been inserted into the accommodation space 320h.

The sensors 350a and 350b may be located outside the resonance unit 320 and may be arranged in one area adjacent to the accommodation space 320h. The sensors 350a and 350b may be located outside the resonance unit 320 so that the sensors 350a and 350b are not heated by the heater assembly 300 using the dielectric heating method.

For example, the sensors 350a and 350b may be arranged inside a support 340. The support 340 may be located outside the resonance unit 320 to surround an outer surface of the aerosol generating article 10 accommodated in or inserted into the accommodation space 320h. Accordingly, the sensors 350a and 350b may be located outside the resonance unit 320 to surround the outer surface of the aerosol generating article 10 accommodated in or inserted into the accommodation space 310h.

For example, the sensor 350a may be a plate-shaped coil which surrounds at least a portion of the outer surface of the aerosol generating article 10 inserted into the accommodation space 320h. In another example, the sensor 350b may be a ring-shaped coil which surrounds the outer surface of the aerosol generating article 10 inserted into the accommodation space 320h. Shapes of the sensors 350a and 350b are not limited to the examples described above.

In the drawings, only one sensor 350a or 350b is shown. However, the number of the sensors 350a and 350b are not limited thereto and may be two, three, or more depending on the embodiment.

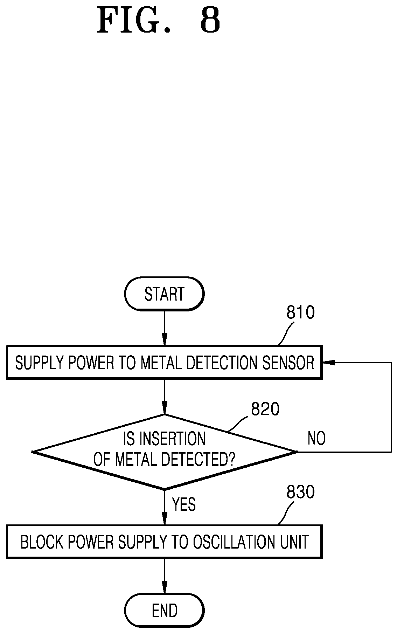

Below, a method of controlling an aerosol generating device based on detection results of the sensors 350a and 350b is described with reference to FIG. 8.

FIG. 8 is a flowchart of a method of controlling an aerosol generating device, according to an embodiment. In describing the method of controlling an aerosol generating device below, reference is made to the elements of the aerosol generating device 100 of FIGS. 1 and 2 and the elements of the heater assembly 200 of FIGS. 3 to 6, 7A, and 7B.

Referring to FIG. 8, in operation 810, the aerosol generating device 100 may supply power from a battery to the sensors 150, 250a, 250b for detecting insertion of metal into the accommodation spaces 110h and 220h. The processor 130 may supply power to the sensors 150, 250a, 250b, 350a, and 350b periodically or discontinuously, preventing unwanted power consumption in the aerosol generating device 100.

For example, the processor 130 may supply power to the sensors 150, 250a, 250b, 350a, and 350b at preset intervals. The processor 130 may apply a ping signal to the sensors 150, 250a, 250b, 350a, and 350b at preset intervals, and may start operating the sensors 150, 250a, 250b, 350a, and 350b only when the ping signal is applied.

In operation 820, the sensors 150, 250a, 250b, 350a, and 350b which have received power may detected a change in inductance of the accommodation spaces 110h and 220h, and the processor 130 may detect whether metal has been inserted into the accommodation spaces 110h and 220h, based on the change in inductance of the accommodation spaces 110h and 220h detected by the sensors 150, 250a, 250b, 350a, and 350b. For example, the processor 130 may detect a change in frequency corresponding to the change in inductance detected by the sensors 150, 250a, 250b, 350a, and 350b, and when it is determined that the detected frequency change is greater than or equal to a preset frequency change, determine that metal has been inserted into the accommodation spaces 110h and 220h.

In operation 830, the processor 130 may detect a change in frequency corresponding to the change in inductance detected by the sensors 150, 250a, 250b, 350a, and 350b, and when it is determined that the detected frequency change is greater than or equal to a preset frequency change, block power supply to the oscillation units 210 and 310.

Because metals includes numerous free electrons therein, when a metal is heated using a dielectric heating method, numerous free electrons in the metal may vibrate or rotate simultaneously. In a state where metal is inserted into the accommodation space 110h, when the heater assembly 200 heats the aerosol generating material 10 by using the dielectric heating method, the heating efficiency of the aerosol generating device 1000 may not be high because the metal is heated faster than the aerosol generating material 10. In some embodiments, the metal may be heated to ignite, causing the aerosol generating device 1000 to explode.

When it is determined that metal has been inserted into the accommodation spaces 110h and 220h, the processor 130 may block the power supply to the oscillation units 210 and 310 so that the aerosol generating device 100 may prevent the risk of failure and/or explosion.

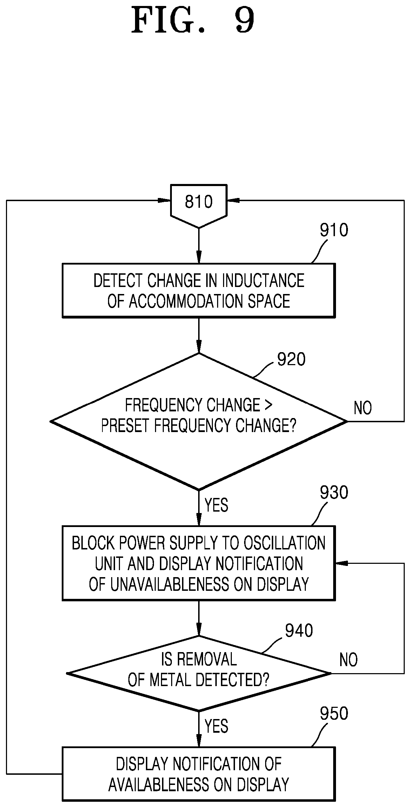

Below, it is described with reference to FIG. 9 a method of controlling such that a notification of unavailableness or availableness of the aerosol generating device 1000 is displayed on the display D.

FIG. 9 is a flowchart of a method of controlling an aerosol generating device, according to another embodiment. FIG. 9 is a flowchart for describing, in detail, operations after operation 810 of FIG. 8. In describing the method of controlling an aerosol generating device below, reference is made to the elements of the aerosol generating device 100 of FIGS. 1 and 2 and the elements of the heater assembly 200 of FIGS. 3 to 6, 7A, and 7B.

Referring to FIG. 9, in operation 910, the processor 130 may detect a change in inductance of the accommodation spaces 110h and 220h by using the sensors 150, 250a, 250b, 350a, and 350b.

In operation 920, the processor 130 may detect a change in frequency corresponding to the change in inductance detected in operation 910, and determine whether the detected frequency change is greater than or equal to a preset frequency change. When the detected frequency change is greater than or equal to the preset frequency change, the processor 130 may block power supply to the oscillation units 210 and 310. For example, the preset frequency change may refer to a change in frequency corresponding to insertion of metal.

Even when a user does not find the metal inserted into the accommodation spaces 110h and 220h and operates the aerosol generating device 1000, the aerosol generating device 1000 may detect the metal inserted into the accommodation spaces 110h and 220h and block power supply to the oscillation units 210 and 310. Therefore, the aerosol generating device 1000 may prevent a potential risk in advance and provide the user with stability of the aerosol generating device 1000.

In operation S920, when the detected frequency change is greater than or equal to the preset frequency change, the processor 130 may display, on the display D, content notifying that the aerosol generating device 1000 is not available.

The user may not find the metal inserted into the accommodation spaces 110h and 220h, and thus, when the aerosol generating device 1000 suddenly stops working due to the metal inserted into the accommodation spaces 110h and 220h, the user may mistake the event for a malfunction of the aerosol generating device 1000. When the metal has been inserted into the accommodation spaces 110h and 220h, a notification of unavailableness of the aerosol generating device 1000 may be displayed on the display D so that the user may not feel uncomfortable even when the aerosol generating device 1000 suddenly stops working.

In operation 940, the sensors 150, 250a, 250b, 350a, and 350b which have received power may detected the change in inductance of the accommodation spaces 110h and 220h, and the processor 130 may detect whether the metal has been removed from the accommodation spaces 110h and 220h, based on the change in inductance of the accommodation spaces 110h and 220h detected by the sensors 150, 250a, 250b, 350a, and 350b.

For example, when the frequency change corresponding to the change in inductance obtained by the sensors 150, 250a, 250b, 350a, and 350b is greater than or equal to the preset frequency change, the processor 130 may detect removal of the metal which had been inserted into the accommodation space. For example, the preset frequency change may refer to a change in frequency corresponding to removal of metal.

In operation S950, when the detected frequency change is greater than or equal to the preset frequency change, the processor 130 may display, on the display D, content notifying that the aerosol generating device 1000 is available.

When the metal is removed from the accommodation spaces 110h and 220h, a notification of unavailableness of the aerosol generating device 1000 may be displayed on the display D, thereby ensuring the user safe use of the aerosol generating device 1000 again.

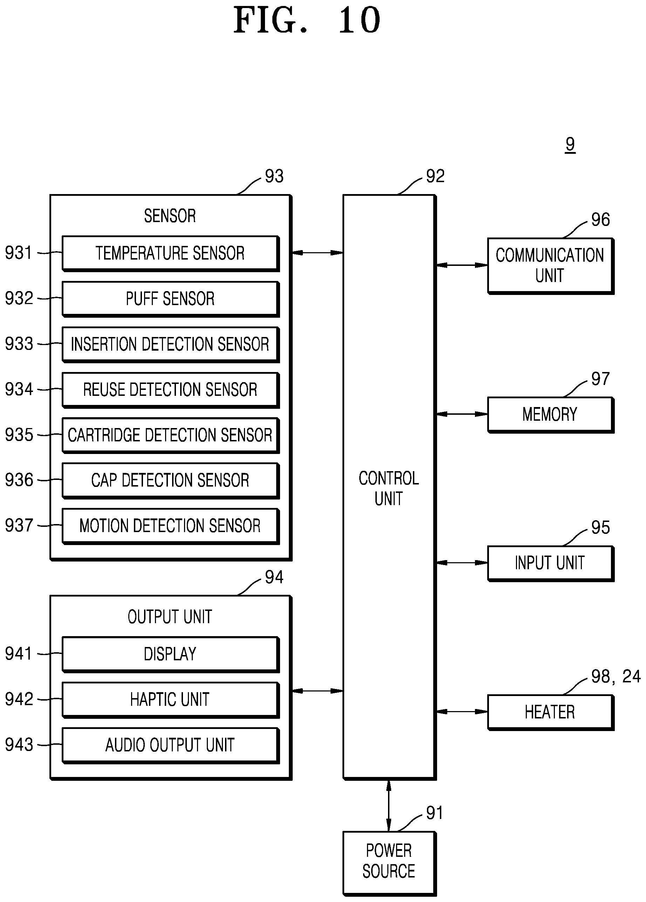

FIG. 10 is a block diagram of an aerosol generating device according to another embodiment.

The aerosol generating device 9 may include a power source 91, a controller 92, a sensor 93, an output unit 94, an input unit 95, a communicator 96, a memory 97, and at least one heater 18 and 24. However, an internal structure of the aerosol generating device 9 is not limited to that illustrated in FIG. 10. In other words, according to the design of the aerosol generating device 9, one of ordinary skill in the art related to the present embodiment that some of the components shown in FIG. 10 may be omitted or new components may be added.

The sensor 93 may detect a state of the aerosol generating device 9 or a state around the aerosol generating device 9 and transmit detected information to the controller 92. On the basis of the detected information, the controller 92 may control the aerosol generating device 9 to perform various functions such as control of operations of the cartridge heater 24 and/or the heater 18, a restriction on smoking, determination of whether or not the stick S and/or the cartridge 19 are inserted, and a notification display.

The sensor 93 may include at least one of a temperature sensor 931, a puff sensor 932, an insertion detection sensor 933, a reuse detection sensor 934, a cartridge detection sensor 935, a cap detection sensor 936, and a motion detection sensor 937.

The temperature sensor 931 may detect a temperature at which the cartridge heater 24 and/or the heater 98 are heated. The aerosol generating device 9 may include a separate temperature sensor for detecting the temperatures of the cartridge heater 24 and/or the heater 98, or the cartridge heater 24 and/or the heater 98 may operate as temperature sensors.

The temperature sensor 931 may output a signal corresponding to the temperature of the cartridge heater 24 and/or the heater 98. For example, the temperature sensor 931 may include a resistor element whose resistance value changes in correspondence to a change in the temperature of the cartridge heater 24 and/or the heater 98. The temperature sensor 931 may be implemented by a thermistor or the like, which is an element using a property of changing resistance according to temperature. Here, the temperature sensor 931 may output a signal corresponding to the resistance value of the resistor element as a signal corresponding to the temperature of the cartridge heater 24 and/or the heater 98. For example, the temperature sensor 931 may include a sensor that detects a resistance value of the cartridge heater 24 and/or the heater 98. Here, the temperature sensor 931 may output a signal corresponding to the resistance value of the cartridge heater 24 and/or the heater 98 as a signal corresponding to the temperature of the cartridge heater 24 and/or the heater 98.

The temperature sensor 931 may be arranged around the power source 91 to monitor a temperature of the power source 91. The temperature sensor 931 may be arranged adjacent to the power source 91. For example, the temperature sensor 931 may be attached to one surface of a battery that is the power source 91. For example, the temperature sensor 931 may be mounted on one surface of a PCB.

The temperature sensor 931 may be arranged inside the body 10 to detect an internal temperature of the body 10.

The puff sensor 932 may detect a puff by a user on the basis of various physical changes in an air flow path. The puff sensor 932 may output a signal corresponding to the puff. For example, the puff sensor 932 may be a pressure sensor. The puff sensor 932 may output a signal corresponding to internal pressure of the aerosol generating device 9. Here, the internal pressure of the aerosol generating device 9 may correspond to pressure of the air flow path through which a gas flows. The puff sensor 932 may be arranged in correspondence to the air flow path through which the gas flows in the aerosol generating device 9.

The insertion detection sensor 933 may detect insertion and/or removal of the stick S. The insertion detection sensor 933 may detect a signal change due to the insertion and/or removal of the stick S. The insertion detection sensor 933 may be installed around an insertion space. The insertion detection sensor 933 may detect the insertion and/or removal of the stick S according to a change in a dielectric constant inside the insertion space. For example, the insertion detection sensor 933 may be an inductive sensor and/or a capacitance sensor.

The inductive sensor may include at least one coil. The coil of the inductive sensor may be arranged adjacent to the insertion space. For example, when a magnetic field changes around the coil through which a current flows, characteristics of the current flowing through the coil may change according to Faraday's law of electromagnetic induction. Here, the characteristics of the current flowing through the coil may include a frequency of an alternating current, a current value, a voltage value, an inductance value, an impedance value, and the like.

The inductive sensor may output a signal corresponding to the characteristics of the current flowing through the coil. For example, the inductive sensor may output a signal corresponding to an inductance value of the coil.

The capacitance sensor may include a conductor. The conductor of the capacitance sensor may be arranged adjacent to the insertion space. The capacitance sensor may output a signal corresponding to an ambient electromagnetic characteristic, e.g., a capacitance around the conductor. For example, when the stick S including a metal wrapper is inserted into the insertion space, the electromagnetic characteristic around the conductor may be changed by the wrapper of the stick S.

The reuse detection sensor 934 may detect whether or not the stick S is reused. The reuse detection sensor 934 may be a color sensor. The color sensor may detect a color of the stick S. The color sensor may detect a color of a portion of the wrapper wrapping the outside of the stick S. The color sensor may detect a value for an optical characteristic corresponding to a color of an object, on the basis of light reflected from the object. For example, the optical characteristic may be a wavelength of light. The color sensor may be implemented as a single component with a proximity sensor or may be implemented as a separate component distinguished from the proximity sensor.

At least a portion of the wrapper constituting the stick S may have a color changing by an aerosol. When the stick S is inserted into the insertion space, the reuse detection sensor 934 may be arranged in correspondence to a location at which at least the portion of the wrapper whose color changes by the aerosol is arranged. For example, before the stick S is used by the user, the color of at least the portion of the wrapper may be a first color. Here, when at least the portion of the wrapper is wetted by the aerosol while the aerosol generated by the aerosol generating device 9 passes through the stick S, the color of at least the portion of the wrapper may be changed to a second color. The color of at least the portion of the wrapper may be maintained in the second color after changing from the first color to the second color.

The cartridge detection sensor 935 may detect mounting and/or removal of the cartridge 19. The cartridge detection sensor 935 may be implemented by an inductance-based sensor, a capacitive sensor, a resistance sensor, a hall sensor (a hall IC) using a hall effect, or the like.

The cap detection sensor 936 may detect mounting and/or removal of a cap. When the cap is detached from the body 10, a portion of the cartridge 19 and the body 10 covered by the cap may be exposed to the outside. The cap detection sensor 936 may be implemented by a contact sensor, a hall sensor (a hall IC), an optical sensor, or the like.

The motion detection sensor 937 may detect a motion of the aerosol generating device 9. The motion detection sensor 937 may be implemented as at least one of an acceleration sensor and a gyro sensor.

In addition to the sensors 131 to 137 described above, the sensor 93 may further include at least one of a humidity sensor, an atmospheric pressure sensor, a magnetic sensor, a position sensor (e.g., a global positioning system (GPS)), and a proximity sensor. Functions of the respective sensors may be intuitively inferred from names thereof by one of ordinary skill in the art, and thus, detailed descriptions thereof may be omitted.

The output unit 94 may output information regarding the state of the aerosol generating device 9 and provide the information to the user. The output unit 94 may include at least one of a display 141, a haptic unit 142, and a sound output unit 943, but is not limited thereto. When the display 141 and a touch pad form a layer structure to form a touch screen, the display 141 may be used as an input device in addition to an output device.

The display 141 may visually provide the user with information regarding the aerosol generating device 9. For example, the information regarding the aerosol generating device 9 may refer to various types of information such as a charging/discharging state of the power source 91 of the aerosol-generating device 9, a preheating state of the heater 98, the insertion/removal state of the stick S and/or the cartridge 19, the mounting/removal state of the cap, and the restriction on use of the aerosol generating device 9 (e.g., detection of an abnormal article), and the display 141 may output the information to the outside. For example, the display 141 may be in the form of a light emitting diode (LED) light emitting device. For example, the display 141 may be a liquid crystal display (LCD) panel, an organic light emitting display (OLED) panel, or the like.

The haptic unit 142 may tactilely provide the user with the information regarding the aerosol generating device 9 by converting an electrical signal into a mechanical stimulus or an electrical stimulus. For example, when initial power is supplied to the cartridge heater 24 and/or the heater 98 for a set time, the haptic unit 142 may generate vibration corresponding to completion of initial preheating. The haptic unit 142 may include a vibration motor, a piezoelectric element, or an electrical stimulation device.

The sound output unit 943 may audibly provide the user with the information regarding the aerosol generating device 9. For example, the sound output unit 943 may convert the electrical signal into a sound signal and output the sound signal to the outside.

The power supply 11 may supply power used to operate the aerosol generating device 9. The power source 91 may supply power so that the cartridge heater 24 and/or the heater 98 may be heated. In addition, the power source 91 may supply power needed for operations of the sensor 93, the output unit 94, the input unit 95, the communicator 96, and the memory 97, which are other components provided within the aerosol generating device 9. The power source 91 may be a rechargeable battery or a disposable battery. For example, the power supply 11 may be a lithium polymer (LiPoly) battery, but is not limited thereto.

Although not shown in FIG. 10, the aerosol generating device 9 may further include a power protection circuit. The power protection circuit may be electrically connected to the power source 91 and may include a switching element.

The power protection circuit may cut off an electrical path for the power source 91 according to a certain condition. For example, the power protection circuit may cut off the electrical path for the power source 91 when a voltage level of the power source 91 is a first voltage or more corresponding to overcharging. For example, the power protection circuit may cut off the electrical path for the power source 91 when the voltage level of the power source 91 is less than a second voltage corresponding to over-discharge.

The heater 98 may be supplied with power from the power source 91 and heat a medium or an aerosol generating material within the stick S. Although not shown in FIG. 10, the aerosol generating device 9 may further include a power conversion circuit (e.g., a DC/DC converter) that converts power of the power source 91 and supplies the converted power to the cartridge heater 24 and/or the heater 98.

In addition, when the aerosol generating device 9 generates an aerosol by an induction heating method, the aerosol generating device 9 may further include a DC/AC converter that converts DC power of the power source 91 into AC power. The controller 92, the sensor 93, the output unit 94, the input unit 95, the communicator 96, and the memory 97 may be supplied with power from the power source 91 to perform functions. Although not shown in FIG. 10, the aerosol generating device 9 may further include a power conversion circuit that converts power of the power source 91 and supplies the power to each of components, e.g., a low-dropout (LDO) circuit or a voltage regulator circuit. The noise filter may be a low pass filter. The low pass filter may include at least one inductor and a capacitor. A cutoff frequency of the low pass filter may correspond to a frequency of a high-frequency switching current applied from the power source 91 to the heater 98. The low pass filter may prevent a high-frequency noise component from being applied to the sensor 93, such as the insertion detection sensor 933.

In an embodiment, the cartridge heater 24 and/or the heater 98 may be formed of any suitable electrically resistive material. For example, the suitable electrically resistive material may be a metal or a metal alloy including titanium, zirconium, tantalum, platinum, nickel, cobalt, chromium, hafnium, niobium, molybdenum, tungsten, tin, gallium, manganese, iron, copper, stainless steel, or nichrome, but is not limited thereto.

In addition, the heater 98 may be implemented by a metal wire, a metal plate on which an electrically conductive track is arranged, or a ceramic heating element, but is not limited thereto. In an embodiment, the heater 98 may include an induction heater. The touch panel may include at least one touch sensor for detecting a touch. For example, the touch sensor may include a capacitive touch sensor, a resistive touch sensor, a surface acoustic touch sensor, an infrared touch sensor, or the like, but is not limited thereto.

The display 141 and the touch panel may be implemented as one panel. For example, the touch panel may be inserted into the display 141 (e.g., may be an on-cell type or in-cell type). For example, the touch panel may be added on the display 141 (e.g., may be an add-on type).

Meanwhile, the input unit 95 may include a button, a keypad, a dome switch, a jog wheel, a jog switch, or the like, but is not limited thereto.

The memory 97 may be hardware for storing various types of data processed within the aerosol generating device 9 and may store pieces of data processed by the controller 92 and pieces of data to be processed by the controller 92. The memory 97 may include at least one type of storage medium from among a flash memory type, a hard disk type, a multimedia card micro type, a card type memory (e.g., a SD or XD memory or the like), random access memory (RAM), static random access memory (SRAM), read-only memory (ROM), electrically erasable programmable read-only memory (EEPROM), programmable read-only memory (PROM), a magnetic memory, a magnetic disk, and an optical disk. The memory 97 may store data or the like regarding an operation time of the aerosol generating device 9, the maximum number of puffs, the current number of puffs, at least one temperature profile, and a smoking pattern of the user.

The communicator 96 may include at least one component for communication with another electronic device. For example, the communicator 96 may include at least one of a short-range wireless communication unit and a wireless communication unit.

The short-range wireless communication unit may include a Bluetooth communication unit, a Bluetooth low energy (BLE) communication unit, a near field communication unit, a wireless local area network ((WLAN) (Wi-Fi)) communication unit, a Zigbee communication unit, an infrared data association (IrDA) communication unit, a Wi-Fi Direct (WFD) communication unit, an ultra wideband (UWB) communication unit, an Ant+ communication unit, and the like, but is not limited thereto.

The wireless communication unit may include a cellular network communication unit, an Internet communication unit, a computer network (e.g., LAN or WAN) communication unit, and the like, but is not limited thereto.

Although not shown in FIG. 10, the aerosol generating device 9 may further include a connection interface such as a universal serial bus (USB) interface, and may connect with another external device through the connection interface such as a USB interface to transmit and receive information or charge the power 11.

The controller 92 may control an overall operation of the aerosol generating device 9. In an embodiment, the controller 92 may include at least one processor. The processor may be implemented as an array of a plurality of logic gates or may be implemented as a combination of a general-purpose microprocessor and a memory that stores a program executable by the microprocessor. In addition, one of ordinary skill in the art to which the present embodiment pertains may understand that the processor may be implemented as other types of hardware.

The controller 92 may control the temperature of the heater 98 by controlling supply power from the power source 91 to the heater 98. The controller 92 may control the temperature of the cartridge heater 24 and/or the heater 98 on the basis of the temperature of the cartridge heater 24 and/or the heater 98 sensed by the temperature sensor 931. The controller 92 may adjust power supplied to the cartridge heater 24 and/or the heater 98, on the basis of the temperature of the cartridge heater 24 and/or the heater 98. For example, the controller 92 may determine a target temperature for the cartridge heater 24 and/or the heater 98, on the basis of a temperature profile stored in the memory 97.

The aerosol generating device 9 may include a power supply circuit (not shown) electrically connected to the power source 91 between the power source 91 and the cartridge heater 24 and/or the heater 98. The power supply circuit may be electrically connected to the cartridge heater 24, the heater 98, or an induction coil. The power supply circuit may include at least one switching element. The switching element may be implemented by a bipolar junction transistor (BJT), a field effective transistor (FET), or the like. The controller 92 may control the power supply circuit.

The controller 92 may control power supply by controlling switching of the switching element of the power supply circuit. The power supply circuit may be an inverter that converts DC power output from the power source 91 into AC power. For example, the inverter may include a full-bridge circuit or a half-bridge circuit including a plurality of switching elements.

The controller 92 may turn on the switching element so that power is supplied from the power source 91 to the cartridge heater 24 and/or the heater 98. The controller 92 may turn off the switching element to cut off the supply of power to the cartridge heater 24 and/or the heater 98. The controller 92 may adjust a current supplied from the power source 91 by adjusting a frequency and/or duty ratio of a current pulse input into the switching element.

The controller 92 may control a voltage output from the power source 91 by controlling switching of the switching element of the power supply circuit. The power conversion circuit may convert the voltage output from the power source 91. For example, the power conversion circuit may include a buck-converter that steps down the voltage output from the power source 91. For example, the power conversion circuit may be implemented through a buck-boost converter, a zener diode, or the like.

The controller 92 may adjust a level of the voltage output from the power conversion circuit by controlling an on/off operation of the switching element included in the power conversion circuit. When the switching element continues to be turned on, the level of the voltage output from the power conversion circuit may correspond to a level of a voltage output from the power source 91. The duty ratio for the on/off operation of the switching element may correspond to a ratio of the voltage output from the power conversion circuit to the voltage output from the power source 91. The level of the voltage output from the power conversion circuit may decrease with a decrease in the duty ratio for the on/off operation of the switching element. The heater 98 may be heated on the basis of the voltage output from the power conversion circuit.

The controller 92 may control power to be supplied to the heater 98 by using at least one of a pulse width modulation (PWM) method and a proportional-integral-differential (PID) method.

For example, the controller 92 may control a current pulse having a certain frequency and duty ratio to be supplied to the heater 98 by using the PWM method. The controller 92 may control the power supplied to the heater 98 by adjusting the frequency and duty ratio of the current pulse.

For example, the controller 92 may determine a target temperature to be controlled, on the basis of the temperature profile. The controller 92 may control the power supplied to the heater 98 by using the PID method, which is a feedback control method through a difference value between the temperature of the heater 98 and the target temperature, a value obtained by integrating the difference value over time, and a value obtained by differentiating the difference value over time.

The controller 92 may prevent the cartridge heater 24 and/or the heater 98 from overheating. For example, on the basis that the temperature of the cartridge heater 24 and/or the heater 98 exceeds a preset limit temperature, the controller 92 may control an operation of the power conversion circuit so that the supply of power to the cartridge heater 24 and/or the heater 98 stops. For example, on the basis that the temperature of the cartridge heater 24 and/or the heater 98 exceeds the preset limit temperature, the controller 92 may reduce an amount of power supplied to the cartridge heater 24 and/or the heater 98 by a certain ratio. For example, on the basis that the temperature of the cartridge heater 24 exceeds the preset limit temperature, the controller 92 may determine that the aerosol generating material accommodated in the cartridge 19 is exhausted and cut off the power supply to the cartridge heater 24.

The controller 92 may control charging and discharging of the power source 91. The controller 92 may identify the temperature of the power source 91 on the basis of an output signal of the temperature sensor 931.

When a power line is connected to a battery terminal of the aerosol generating device 9, the controller 92 may identify whether or not the temperature of the power source 91 is a first limit temperature or more which is a reference for blocking charging of the power source 91. When the temperature of the power source 91 is less than the first limit temperature, the controller 92 may control the power source 91 to be charged, on the basis of a preset charging current. The controller 92 may block charging of the power source 91 when the temperature of the power source 91 is the first limit temperature or more.

While the power of the aerosol generating device 9 is turned on, the controller 92 may identify whether or not the temperature of the power source 91 is a second limit temperature or more which is a reference for blocking discharge of the power source 91. The controller 92 may control power stored in the power source 91 to be used when the temperature of the power source 91 is less than the second limit temperature. When the temperature of the power source 91 is the second limit temperature or more, the controller 92 may stop using the power stored in the power source 91.

The controller 92 may calculate a remaining capacity of the power stored in the power source 91. For example, the controller 92 may calculate the remaining capacity of the power source 91 on the basis of a voltage and/or current sensing value of the power source 91.

The controller 92 may determine, through the insertion detection sensor 933, whether or not the stick S is inserted into the insertion space. The controller 92 may determine that the stick S is inserted, on the basis of the output signal of the insertion detection sensor 933. When determining that the stick S is inserted into the insertion space, the controller 92 may control power to be supplied to the cartridge heater 24 and/or the heater 98. For example, the controller 92 may supply power to the cartridge heater 24 and/or the heater 98, on the basis of the temperature profile stored in the memory 97.

The controller 92 may determine whether or not the stick S is removed from the insertion space. For example, the controller 92 may determine, through the insertion detection sensor 933, whether or not the stick S is removed from the insertion space. For example, when the temperature of the heater 98 is the preset limit temperature or more or when a temperature change gradient of the heater 98 is a set gradient, the controller 92 may determine that the stick S is removed from the insertion space. When determining that the stick S is removed from the insertion space, the controller 92 may cut off the supply of power to the cartridge heater 24 and/or the heater 98.

The controller 92 may control a power supply time and/or a power supply amount with respect to the heater 98, according to a state of the stick S detected by the sensor 93. The controller 92 may identify, on the basis of a look-up table, a level range including a level of a signal of the capacitance sensor. The controller 92 may determine an amount of moisture in the stick S, according to the identified level range.

When the stick S is over-humidified, the controller 92 may increase a preheating time of the stick S compared to a normal state by controlling the power supply time with respect to the heater 98.

The controller 92 may determine, through the reuse detection sensor 934, whether or not the stick S inserted into the insertion space is reused. For example, the controller 92 may compare a sensing value of a signal of the reuse detection sensor 934 with a first reference range including a first color and when the sensing value is included in the first reference range, determine that the stick S is not used. For example, the controller 92 may compare the sensing value of the signal of the reuse detection sensor 934 with a second reference range including a second color and when the sensing value is included in the second reference range, determine that the stick S is used. When determining that the stick S is used, the controller 92 may cut off the supply of power to the cartridge heater 24 and/or the heater 98.

The controller 92 may determine, through the cartridge detection sensor 935, whether or not the cartridge 19 is coupled and/or removed. For example, the controller 92 may determine whether or not the cartridge 19 is coupled or removed, on the basis of a sensing value of the signal of the cartridge detection sensor 935.

The controller 92 may determine whether or not the aerosol generating material of the cartridge 19 is exhausted. For example, the controller 92 may apply power to preheat the cartridge heater 24 and/or the heater 98, determine whether or not the temperature of the cartridge heater 24 exceeds the limit temperature in a preheating period, and when the temperature of the cartridge heater 24 exceeds the limit temperature, determine that the aerosol generating material of the cartridge 19 is exhausted. When determining that the aerosol generating material of the cartridge 19 is exhausted, the controller 92 may cut off the supply of power to the cartridge heater 24 and/or the heater 98.

The controller 92 may determine whether or not the cartridge 19 may be usable. When the current number of puffs is greater than or equal to the maximum number of puffs set in the cartridge 19, the controller 92 may determine, on the basis of data stored in the memory 97, that the cartridge 19 may not be usable. For example, when the total time for which the heater 24 is heated is a preset maximum time or more or the total amount of power supplied to the heater 24 is a preset maximum amount of power or more, the controller 92 may determine that the cartridge 19 may not be usable.

The controller 92 may determine inhalation by the user through the puff sensor 932. For example, the controller 92 may determine whether or not a puff occurs, on the basis of a sensing value of a signal of the puff sensor 932. For example, the controller 92 may determine an intensity of the puff, on the basis of the sensing value of the signal of the puff sensor 932. When the number of puffs reaches the preset maximum number of puffs or when puffs are not detected for a preset time or more, the controller 92 may cut off the supply of power to the cartridge heater 24 and/or the heater 98.

The controller 92 may determine, through the cap detection sensor 936, whether a cap is coupled and/or removed. For example, the controller 92 may determine whether or not the cap is coupled and/or removed, on the basis of a sensing value of a signal of the cap detection sensor 936.

The controller 92 may control the output unit 94 on the basis of the result of detection by the sensor 93. For example, when the number of puffs counted through the puff sensor 932 reaches a preset number, the controller 92 may notify the user that the aerosol generating device 9 is soon terminated, through at least one of the display 141, the haptic unit 942, and the sound output unit 943. For example, the controller 92 may notify the user through the output unit 94 that the stick S is not present in the insertion space, on the basis of the determination that the stick S is not present in the insertion space. For example, the controller 92 may notify the user through the output unit 94 that the cartridge 19 and/or the cap are not mounted, on the basis of the determination that the cartridge 19 and/or the cap are not mounted. For example, the controller 92 may transmit information regarding the temperature of the cartridge heater 24 and/or the heater 98 to the user through the output unit 94.

The controller 92 may store and update, in the memory 97, a history of a certain event that occurs, on the basis of the occurrence of the event. The event may include detection of insertion of the stick S, initiation of heating of the stick S, detection of puffs, termination of the puffs, detection of overheating of the cartridge heater 24 and/or the heater 98, detection of application of an overvoltage to the cartridge heater 24 and/or the heater 98, termination of heating of the stick S, an operation such as power on/off of the aerosol generating device 9, initiation of charging of the power source 91, detection of overcharging of the power source 91, termination of charging of the power source 91, and the like. The history of the event may include a date and time when the event occurs, log data corresponding to the event, and the like. For example, when the certain event is the detection of insertion of the stick S, the log data corresponding to the event may include data regarding the sensing value of the insertion detection sensor 933 and the like. For example, when the certain event is the detection of overheating of the cartridge heater 24 and/or the heater 98, the log data corresponding to the event may include data regarding the temperature of the cartridge heater 24 and/or the heater 98, the voltage applied to the cartridge heater 24 and/or the heater 98, a current flowing through the cartridge heater 24 and/or the heater 98, and the like.

The controller 92 may control to form a communication link with an external device such as a mobile terminal of the user. When data regarding authentication is received from the external device through the communication link, the controller 92 may release a restriction on use of at least one function of the aerosol generating device 9. Here, the data regarding the authentication may include data indicating completion of user authentication for the user corresponding to the external device. The user may perform the user authentication through the external device. The external device may determine whether or not user data is valid, on the basis of the birthday of the user, a unique number indicating the user, and the like and receive, from an external server, data regarding use authority over the aerosol generating device 9. The external device may transmit the data indicating the completion of the user authentication to the aerosol generating device 9, on the basis of the data regarding the use authority. When the user authentication is completed, the controller 92 may release the restriction on the use of at least one function of the aerosol generating device 9. For example, when the user authentication is completed, the controller 92 may release a restriction on use of a heating function of supplying power to the heater 98.

The controller 92 may transmit data regarding the state of the aerosol generating device 9 to the external device through the communication link formed with the external device. On the basis of the received data regarding the state of the aerosol generating device 9, the external device may output the remaining capacity of the power source 91 of the aerosol generating device 9, an operation mode, and the like through a display of the external device.

The external device may transmit a location search request to the aerosol generating device 9, on the basis of an input for initiating a location search of the aerosol generating device 9. When receiving the location search request from the external device, the controller 92 may control at least one of output devices to perform an operation corresponding to the location search, on the basis of the received location search request. For example, the haptic unit 942 may generate vibration in response to the location search request. For example, the display 941 may output an object corresponding to the location search and an end of the search in response to the location search request.

When receiving firmware data from the external device, the controller 92 may control to perform a firmware update. The external device may identify a current version of firmware of the aerosol generating device 9 and determine whether or not a new version of the firmware is present. When an input for requesting firmware download is received, the external device may receive a new version of firmware data and transmit the new version of firmware data to the aerosol generating device 9. When receiving the new version of firmware data, the controller 92 may control the firmware update of the aerosol generating device 9 to be performed.

The controller 92 may transmit data regarding a sensing value of at least one sensor 93 to the external server (not shown) through the communicator 96, and receive from the server and store a learning model generated by learning the sensing value through machine learning such as deep learning. The controller 92 may perform an operation of determining an inhalation pattern of the user, an operation of generating a temperature profile, and the like by using the learning model received from the server. The controller 92 may store, in the memory 97, sensing value data of at least one sensor 93, data for training an artificial neural network (ANN), and the like. For example, the memory 97 may store a database for each component provided in the aerosol generating device 9, which is for training the ANN, and weights and biases constituting the structure of the ANN. The controller 92 may generate at least one learning model used for determining the inhalation pattern of the user, generating the temperature profile, and the like, by learning data regarding the sensing value of the at least one sensor 93, the inhalation pattern of the user, the temperature profile, and the like which are stored in the memory 97.

Any of the embodiments or other embodiments of the present disclosure described above are not mutually exclusive or distinct. Any of the embodiments or other embodiments of the present disclosure described above may be combined or combined in their respective configurations or functions.

For example, it means that the A configuration described in a specific embodiment and/or the drawings and the B configuration described in another embodiment and/or the drawings may be combined. That is, even if the combination between the configurations is not directly described, it means that the combination is possible, except in cases where the combination is described as impossible.

The above detailed description should not be construed as limiting in all respects, but should be considered as illustrative. The scope of the present disclosure should be determined by a reasonable interpretation of the appended claims, and all changes within the equivalent scope of the present disclosure are included in the scope of the present disclosure.

## Claims

1. An aerosol generating device comprising:
a housing;
a heater assembly comprising an oscillation unit configured to generate a microwave in a designated frequency band and a resonation unit configured to receive the generated microwave from the oscillation unit through a coupler and generate an electric field by resonating the received microwave;
a sensor arranged inside the housing and configured to detect insertion of a metal into an accommodation space for accommodating an aerosol generating article therein; and
a processor electrically connected to the sensor and configured to block power supply to the oscillation unit when the insertion of the metal into the accommodation unit is detected.

2. The aerosol generating device of claim 1, wherein the sensor is located outside the resonation unit and arranged in one area adjacent to the accommodation space.

3. The aerosol generating device of claim 1, further comprising a support located outside the resonation unit, and arranged to surround an outer surface of the aerosol generating article accommodated in the accommodation space to support the accommodated aerosol generating article,
wherein the sensor is arranged inside the support.

4. The aerosol generating device of claim 1, wherein the sensor is a ring-shaped coil which surrounds an outer surface of the aerosol generating article inserted into the accommodation space.

5. The aerosol generating device of claim 1, wherein the sensor is a plate-shaped coil which surrounds an outer surface of the aerosol generating article inserted into the accommodation space.

6. The aerosol generating device of claim 1, wherein, when the processor supplies power to the sensor at preset intervals, the sensor detects a change in inductance of the accommodation space at the preset intervals.

7. The aerosol generating device of claim 1, wherein the sensor detects a change in inductance of the accommodation space, and
when a frequency change corresponding to the change in inductance detected by the sensor is greater than or equal to a preset frequency change, the processor blocks a power supply to the oscillation unit.

8. The aerosol generating device of claim 1, further comprising a display arranged in one area of the housing,
wherein, when the insertion of the metal into the accommodation space is detected by the sensor, the processor controls the display to display a notification of unavailableness of the aerosol generating device.

9. The aerosol generating device of claim 8, wherein, when removal of
the metal which had been inserted into the accommodation space is detected by the sensor, the processor controls the display to display a notification of availableness of the aerosol generating device.

10. The aerosol generating device of claim 1, wherein the resonation unit comprises:
an outer conductor comprising a first surface, a second surface facing the first surface, a side surface surrounding an internal space between the first surface and the second surface, and the accommodation space; and
a first internal conductor which extends in a direction from the first surface toward the internal space to surround one area of the aerosol generating article accommodated in the accommodation space.

11. The aerosol generating device of claim 10, wherein the resonation unit further comprises a second internal conductor which extends in a direction from the second surface toward the internal space to surround another area of the accommodated aerosol generating article.

12. The aerosol generating device of claim 10, wherein the resonation unit further comprises:
a dielectric accommodation space formed between the outer conductor and the first internal conductor; and
a dielectric arranged in the dielectric accommodation space.

13. The aerosol generating device of claim 12, wherein the dielectric is spaced apart from the second surface or side surface of the outer conductor by a certain distance.

14. A method of controlling an aerosol generating device, the method comprising:
detecting, by a sensor arranged inside a housing, insertion of a metal into an accommodation space for accommodating an aerosol generating article; and
when the insertion of the metal into the accommodation space is detected by the sensor, blocking power supply to an oscillation unit.

15. The method of claim 14, wherein the detecting of the insertion of the metal comprises detecting based on a change in inductance of the accommodation space detected by the sensor, and
the blocking of the power supply to the oscillation unit comprises, when a frequency change corresponding to the detected change in inductance is greater than or equal to a preset frequency change, blocking the power supply to the oscillation unit.
